# EUROPEAN PATENT APPLICATION

(11) **EP 4 851 327 A1**
(43) Date of publication of application: **09.12.2026**
(21) Application number: 26181991.6
(22) Date of filing: 29.05.2026
(51) Int. Cl.: C23C 16/30, C23C 16/455, H10H 20/01

(54) **THERMAL ATOMIC LAYER DEPOSITION METHOD, METHOD OF MANUFACTURING LIGHT EMITTING ELEMENT USING THE SAME, AND ELECTRONIC DEVICE INCLUDING THE LIGHT EMITTING ELEMENT**

(30) Priority: 29.05.2025 KR 20250070818
(71) Applicant: Samsung Display Co., Ltd., Yongin-si, Gyeonggi-do 17113 (KR); INDUSTRY ACADEMY COOPERATION FOUNDATION OF SEJONG UNIVERSITY, Seoul 05006 (KR)
(72) Inventor: KIM, In Hyuk, Yongin-si, Gyeonggi-do 17113 (KR); LEE, Won-Jun, Seoul 05006 (KR); KIM, Okhyeon, Seoul 05006 (KR); YOO, Chul Jong, Yongin-si, Gyeonggi-do 17113 (KR); LEE, Dong Eon, Yongin-si, Gyeonggi-do 17113 (KR); LEE, Byung Ju, Yongin-si, Gyeonggi-do 17113 (KR); JAINURI, Khabib Khumaini, Seoul 05006 (KR); CHO, Gyejun, Seoul 05006 (KR); CHA, Hyung Rae, Yongin-si, Gyeonggi-do 17113 (KR); CHOI, Yerim, Seoul 05006 (KR); HEO, Jian, Seoul 05006 (KR)
(74) Representative: Marks & Clerk LLP

(57) **Abstract**

A thermal atomic layer deposition method includes performing a thermal atomic layer deposition cycle a plurality of times. The thermal atomic layer deposition cycle includes supplying a precursor to a chamber loaded with a substrate on which electroluminescent stacked elements are provided; and supplying a reactant to the chamber. The precursor includes at least one selected from a group consisting of tris(dimethylamine)gallium (TDMAGa) and tris(dimethylamino)aluminium (TDMAA), and the reactant includes at least a nitrogen atom. The performing the thermal atomic layer deposition cycle a plurality of times is performed at a temperature of 150 °C above and 400 °C below.

## Description

### BACKGROUND

### 1. Field

Embodiments of the present disclosure relate to a thermal atomic layer deposition method, a method of manufacturing a light emitting element using the thermal atomic layer deposition method, and a display device including the light emitting element.

### 2. Description of the Related Art

A display device is a device that includes a light emitting element that emits light and uses it to display an image. In recent years, research has been actively conducted on display devices that utilize an ultra-small light emitting element (e.g., micro LED) as a light emitting element to secure high integration.

The light emitting element may include an electroluminescent stacked element including semiconductor layers and an active layer between them. However, as a light emitting element is miniaturized, the electroluminescent stacked element is also miniaturized, and in such cases, it has been difficult to secure sufficient external quantum efficiency (EQE) of the light emitting element.

### SUMMARY

Embodiments of the present disclosure provide a thermal atomic layer deposition method to provide a light emitting element with improved luminous efficiency.

Embodiments of the present disclosure provide a method of manufacturing a light emitting element using the thermal atomic layer deposition method.

Embodiments of the present disclosure provide an electronic device including a light emitting element manufactured by the method of manufacturing a light emitting element.

A thermal atomic layer deposition method according to embodiments of the present disclosure includes performing a thermal atomic layer deposition cycle a plurality of times. The thermal atomic layer deposition cycle includes supplying a precursor to a chamber loaded with a substrate on which electroluminescent stacked elements are provided; and supplying a reactant to the chamber. The precursor includes at least one selected from a group consisting of tris(dimethylamide)gallium (TDMAGa) and tris(dimethylamino)aluminium (TDMAA). The reactant includes at least a nitrogen atom. The performing the thermal atomic layer deposition cycle a plurality of times is performed at a temperature of 150 °C or above and 400 °C or below (e.g., in a range of 150 °C to 400 °C).

In an embodiment, the thermal atomic layer deposition cycle may include a first thermal atomic layer deposition cycle. In an embodiment, the first thermal atomic layer deposition cycle may include supplying tris(dimethylamide)gallium (TDMAGa) to the chamber; and supplying the reactant to the chamber.

In an embodiment, the first thermal atomic layer deposition cycle may be performed at a temperature of 300 °C or below (e.g., in a range of 150 °C to 300 °C).

In an embodiment, the thermal atomic layer deposition cycle may include a second thermal atomic layer deposition cycle. The second thermal atomic layer deposition cycle may include supplying tris(dimethylamino)aluminium (TDMAA) to the chamber; and supplying the reactant to the chamber.

In an embodiment, the performing the thermal atomic layer deposition cycle a plurality of times may include performing the first thermal atomic layer deposition cycle a plurality of times; performing the first thermal atomic layer deposition cycle and the second thermal atomic layer deposition cycle alternately a plurality of times; and performing the second thermal atomic layer deposition cycle a plurality of times.

In an embodiment, the performing the first thermal atomic layer deposition cycle and the second thermal atomic layer deposition cycle alternately a plurality of times may be performed at a temperature of 300 °C or below (e.g., in a range of 150 °C to 300 °C).

In an embodiment, the reactant may include NH₃.

A method of manufacturing a light emitting element according to embodiments of the present disclosure includes loading a substrate on which electroluminescent stacked elements are provided into a chamber; and forming a first insulating layer (e.g., a first electrically insulating layer) directly covering outer peripheral surfaces of the electroluminescent stacked elements by performing a thermal atomic layer deposition cycle a plurality of times. The thermal atomic layer deposition cycle includes supplying a precursor into the chamber; and supplying a reactant into the chamber. The precursor includes at least one selected from a group consisting of tris(dimethylamide)gallium (TDMAGa) and tris(dimethylamino)aluminium (TDMAA). The reactant includes at least a nitrogen atom. The forming the first insulating layer is performed at a temperature of 150 °C or above and 400 °C or below (e.g., in a range of 150 °C to 400 °C).

In an embodiment, the method of manufacturing a light emitting element may further include removing a native oxide layer on the outer peripheral surfaces of the electroluminescent stacked elements.

In an embodiment, the removing the native oxide layer may be performed prior to loading the substrate into the chamber.

In an embodiment, the method of manufacturing a light emitting element may further include forming a second insulating layer (e.g., a first electrically insulating layer) directly covering the first insulating layer. The second insulating layer may include an oxide layer.

In an embodiment, each of the electroluminescent stacked elements may include a first semiconductor layer having a first polarity, a second semiconductor layer having a second polarity different from the first polarity, and an active layer between the first semiconductor layer and the second semiconductor layer. The first semiconductor layer and the second semiconductor layer may include at least one selected from a group consisting of gallium nitride (GaN), aluminium nitride (AIN), and aluminium gallium nitride (AlGaN).

In an embodiment, the thermal atomic layer deposition cycle may include a first thermal atomic layer deposition cycle. The first thermal atomic layer deposition cycle may include supplying tris(dimethylamide)gallium (TDMAGa) to the chamber; and supplying the reactant to the chamber.

In an embodiment, the first thermal atomic layer deposition cycle may be performed at a temperature of 300 °C or below (e.g., in a range of 150 °C to 300 °C).

In an embodiment, the thermal atomic layer deposition cycle may include a second thermal atomic layer deposition cycle. The second thermal atomic layer deposition cycle may include supplying tris(dimethylamino)aluminium (TDMAA) to the chamber; and supplying the reactant to the chamber.

In an embodiment, the forming the first insulating layer may include forming a first-1 insulating layer (e.g., a first-1 electrically insulating layer) directly covering the outer peripheral surfaces of the electroluminescent stacked elements by performing the first thermal atomic layer deposition cycle a plurality of times; forming a first-2 insulating layer (e.g., a first-2 electrically insulating layer) directly covering the first-1 insulating layer by performing the first thermal atomic layer deposition cycle and the second thermal atomic layer deposition cycle alternately a plurality of times; and forming a first-3 insulating layer (e.g., a first-3 electrically insulating layer) directly covering the first-2 insulating layer by performing the second thermal atomic layer deposition cycle a plurality of times.

In an embodiment, the forming the first-2 insulating layer may be performed at a temperature of 300 °C or below (e.g., in a range of 150 °C to 300 °C).

In an embodiment, the first-1 insulating layer may include gallium nitride (GaN). The first-2 insulating layer may include aluminium gallium nitride (AlGaN). The first-3 insulating layer may include aluminium nitride (AIN).

In an embodiment, the reactant may include NH₃.

An electronic device according to embodiments of the present disclosure includes a display device to display an image; and a processor to provide image data signals to the display device. The display device includes a light emitting element. The light emitting element is manufactured by the method described above.

At least some of the above and other features of the invention are set out in the claims.

According to embodiments of the present disclosure, a nitride layer directly covering an outer peripheral surface of an electroluminescent stacked element can be formed using a thermal atomic layer deposition method performed without plasma at or under a relatively low temperature. According to the nitride layer formed thereby, a sidewall defect of the electroluminescent stacked element may be reduced, and an external quantum efficiency of the electroluminescent stacked element may be improved.

### BRIEF DESCRIPTION OF THE DRAWINGS

The accompanying drawings, together with the specification, illustrate embodiments of the subject matter of the present disclosure, and, together with the description, serve to explain principles of embodiments of the subject matter of the present disclosure.
FIG. 1 is a schematic diagram to illustrate a deposition apparatus according to an embodiment of the present disclosure.
FIG. 2 is a schematic plan view to illustrate a deposition object including a substrate on which electroluminescent stacked elements are provided.
FIG. 3 is a schematic cross-sectional view to illustrate an embodiment of the deposition object of FIG. 2.
FIG. 4 is a schematic cross-sectional view to illustrate another embodiment of the deposition object of FIG. 2.
FIG. 5 is a diagram to illustrate a thermal atomic layer deposition method of the present disclosure.
FIG. 6 is a diagram to illustrate a first thermal atomic layer deposition cycle.
FIG. 7 is a diagram to illustrate a second thermal atomic layer deposition cycle.
FIG. 8 is a flowchart to illustrate a first embodiment of a thermal atomic layer deposition method of the present disclosure.
FIG. 9A, FIG. 9B, and FIG. 9C are a set of TEM images to illustrate a coherent interface of a first insulating layer (e.g., a first electrically insulating layer) formed by the thermal atomic layer deposition method of FIG. 8.
FIG. 10 is a TEM image to illustrate step coverage of the first insulating layer formed by the thermal atomic layer deposition method of FIG. 8.
FIG. 11 is a flowchart to illustrate a second embodiment of the thermal atomic layer deposition method of the present disclosure.
FIG. 12A and FIG. 12B are a set of TEM images to illustrate a coherent interface of a first insulating layer (e.g., a first electrically insulating layer) formed by the thermal atomic layer deposition method of FIG. 11.
FIG. 13 is a TEM image to illustrate step coverage of the first insulating layer formed by the thermal atomic layer deposition method of FIG. 11.
FIG. 14 is a flowchart to illustrate a third embodiment of the thermal atomic layer deposition method of the present disclosure.
FIG. 15 is a flowchart to illustrate a method of manufacturing a light emitting element of the present disclosure.
FIG. 16 is a schematic cross-sectional view to illustrate a first embodiment of a first insulating layer (e.g., a first electrically insulating layer) formed by the act of forming the first insulating layer of FIG. 15.
FIG. 17 is a schematic cross-sectional view to illustrate a second embodiment of the first insulating layer formed by the act of forming the first insulating layer of FIG. 15.
FIG. 18 is a schematic cross-sectional view to illustrate a third embodiment of the first insulating layer formed by the act of forming the first insulating layer of FIG. 15.
FIG. 19 is a schematic cross-sectional view to illustrate an act of removing a natural oxide layer.
FIG. 20A, FIG. 20B, FIG. 20C, FIG. 20D, FIG. 20E, and FIG. 20F are a set of TEM images to illustrate that a coherent interface is substantially absent if (e.g., when) the first insulating layer is formed without performing the act of removing the natural oxide layer.
FIG. 21 is a schematic cross-sectional view to illustrate an act of forming a second insulating layer (e.g., a second electrically insulating layer).
FIG. 22 is a schematic cross-sectional view to illustrate an act of forming an opening.
FIG. 23 is a schematic cross-sectional view to illustrate an act of forming a bonding electrode.
FIG. 24 is a schematic cross-sectional view to illustrate an act of isolating the light emitting element.
FIG. 25 is a schematic perspective view illustrating the light emitting element of FIG. 24.
FIG. 26 is a schematic plan view to illustrate a display device according to an embodiment of the present disclosure.
FIG. 27 is a schematic cross-sectional view cut along line I3-I4 of FIG. 26.
FIGS. 28 to 30 are graphs illustrating the external quantum efficiency of a light emitting element according to material constituting the insulating layer of FIG. 27.
FIG. 31 is a block diagram of an electronic device according to an embodiment.
FIG. 32 is a schematic diagram of an electronic device according to various suitable embodiments.

### DETAILED DESCRIPTION

Hereinafter, example embodiments according to the present disclosure will be described in more detail with reference to the accompanying drawings. It should be understood that in the following description, only those portions necessary to understand the operation according to embodiments of the present disclosure will be described, and other portions may be omitted so as not to obscure the main points of the present disclosure. Furthermore, the present disclosure is not limited to the embodiments described herein and may be embodied in other forms. However, the embodiments described herein are provided to illustrate the technical ideas of the present disclosure in sufficient detail to facilitate the practice of the present disclosure by one having ordinary skill in the technical field to which the present disclosure belongs.

Throughout the specification, if (e.g., when) a part is said to be "connected" to another part, this includes not only if (e.g., when) it is "directly connected" but also if (e.g., when) it is "indirectly connected" with another element in between. The terminology used herein is intended to describe certain embodiments and is not intended to limit the present disclosure. Throughout the specification, if (e.g., when) a part is said to "include" a component, it is meant to be inclusive of other components, not exclusive of other components, unless specifically noted to the contrary. "At least one of X, Y, and Z" and "at least one selected from an array including X, Y, and Z" can be interpreted as one X, one Y, one Z, or any combination of two or more of X, Y, and Z (e.g., XYZ, XYY, YZ, ZZ). As used herein, "and/or" includes any combination of one or more of those configurations.

As used herein, terms such as first, second, and the like may be used to describe various components, but such components are not limited to such terms. These terms are used to distinguish one component from another. Thus, a first component may refer to a second component without departing from what is disclosed herein.

Spatially relative terms such as "under", "below", "on", "above", and the like may be used for purposes of description, and in so doing, describe the relationship of one element or feature to another element or feature as shown in the drawings. Spatially relative terms are intended to include, in addition to the orientations depicted in the drawings, other orientations in use, operation, and/or manufacture. For example, if (e.g., when) a device shown in the drawings is inverted, elements depicted as being located "under" other elements or features are oriented "on" other elements or features. Thus, in an embodiment, the term "under" may include both up and down directions. Furthermore, the device may be oriented in other directions (e.g., rotated 90 degrees or otherwise), and the spatially relative terms used herein are to be interpreted accordingly.

Various embodiments are described with reference to the drawings, which illustrate embodiments. Accordingly, it is to be expected that the geometries may suitably vary, for example, due to tolerances and/or manufacturing techniques. Accordingly, the embodiments disclosed herein should not be construed as being limited to the particular geometries shown, but should be construed to include changes in geometry that occur, for example, as a result of manufacturing. As such, the shapes illustrated in the drawings may not represent the actual shapes of the regions of the device, and the embodiments are not limited thereto.

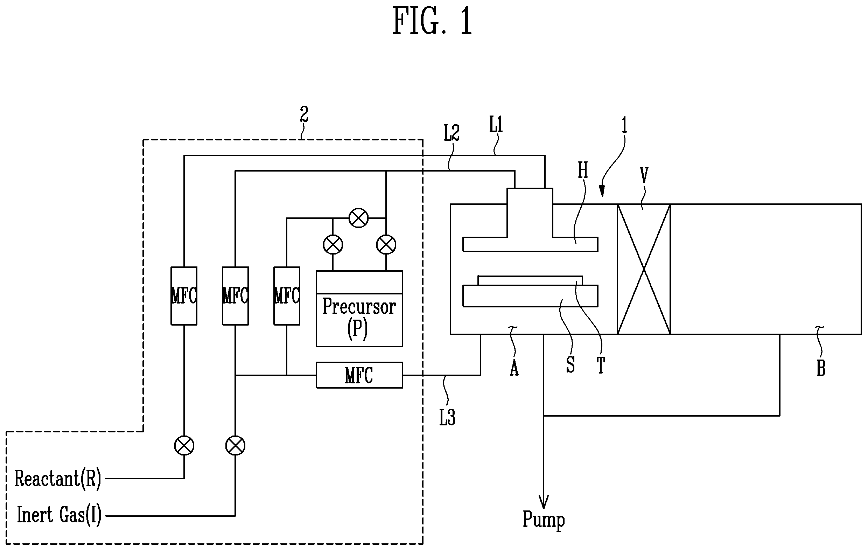

FIG. 1 is a schematic diagram to illustrate a deposition apparatus according to an embodiment of the present disclosure.

Referring to FIG. 1, the deposition apparatus may include a reactor 1 receiving a deposition object T and a gas supply unit 2 supplying a precursor P, a reactant R, and an inert gas I to the reactor 1.

The reactor 1 may include a chamber A with an embedded support portion S to support a deposition object T, and a showerhead H including a plurality of spray holes directed at the deposition object T. In an embodiment, the support portion S may include a heater, which may heat the deposition object T to regulate the temperature of the deposition object T.

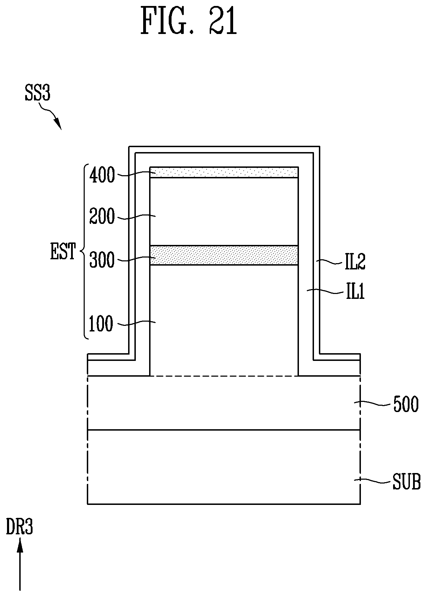

In an embodiment, the reactor 1 may further include a load lock chamber B, and a gate valve V. While a thermal atomic layer deposition method is being performed in the chamber A, the load lock chamber B may be isolated from the chamber A by the gate valve V. If the deposition object T, on which the thermal atomic layer deposition method has been terminated, requires an additional process (e.g., formation of a second insulating layer IL2 (e.g., a second electrically insulating layer IL2), see FIG. 21) to be performed, the gate valve V may be opened and the deposition object T may be transferred from the chamber A to the load lock chamber B. In this case, the transfer of the deposition object T may be carried out without being exposed to the atmosphere (e.g. in a vacuum atmosphere).

The gas supply unit 2 may include at least one canister to receive the precursor P, and a mass flow controller (MFC) to control the flow of gases (e.g., carrier gas to transport the precursor P to the reactor 1, purge gas to purge the reactor 1, and/or the like). The gas supply unit 2 may include gas supply lines L1, L2, and L3 between the canister, the MFC, and the reactor 1, and a plurality of valves to control the flow rate. Through the gas supply lines L1, L2, and L3, the precursor P, the reactant R, and/or an inert gas I may be transported to the reactor 1. While FIG. 1 illustrates only one canister receiving the precursor P, the present disclosure is not limited thereto. For example, in addition to the canister containing the precursor P, there may be additional canisters containing other precursors of different types or kinds.

While a deposition apparatus has been described with reference to FIG. 1, the present disclosure is not limited thereto. The thermal atomic layer deposition method of the present disclosure described herein may be performed using various suitable deposition devices generally used in the art in addition to the deposition device of FIG. 1.

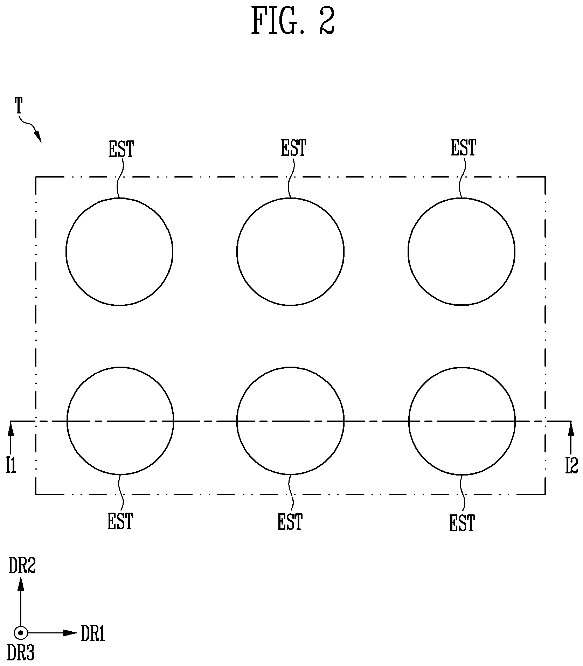

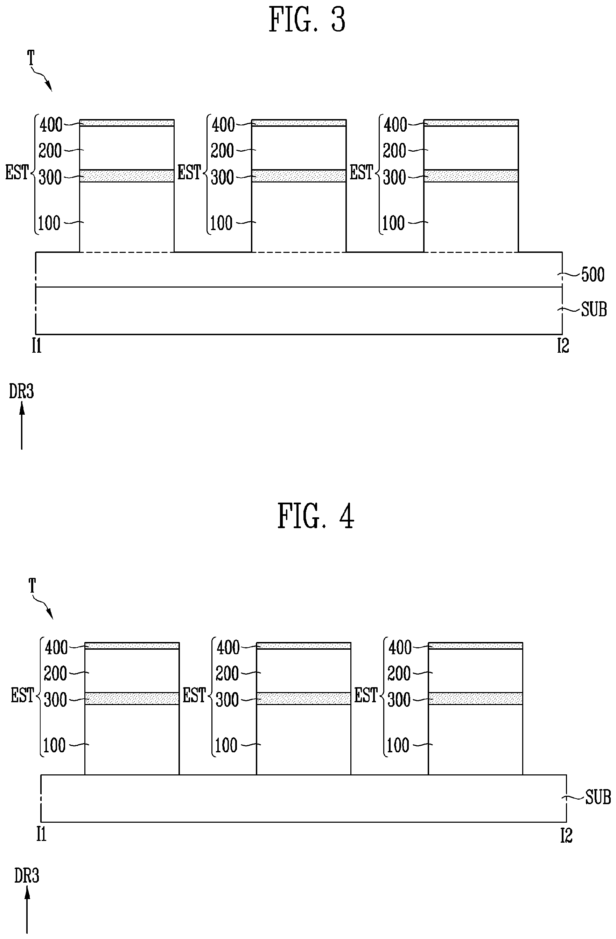

FIG. 2 is a schematic plan view to illustrate a deposition object including a substrate on which electroluminescent stacked elements are provided. FIG. 3 is a schematic cross-sectional view to illustrate an embodiment of the deposition object of FIG. 2.

Referring to FIGS. 2 and 3, the deposition object T may include a substrate SUB, an underlying semiconductor layer 500 (or base semiconductor layer), and electroluminescent stacked elements EST (or light emitting laminates).

The substrate SUB may include, for example, a sapphire substrate. However, the material of the substrate SUB is not limited thereto. The substrate SUB may include a variety of suitable materials generally used in the art to perform semiconductor processes (e.g., epitaxial growth processes).

The underlying semiconductor layer 500 may be on the substrate SUB. In an embodiment, the underlying semiconductor layer 500 may be entirely on the substrate SUB.

The electroluminescent stacked elements EST may be on top of the underlying semiconductor layer 500. The electroluminescent stacked elements EST may be spaced apart from each other. For example, the electroluminescent stacked elements EST may be arranged in a matrix along a first direction DR1 and a second direction DR2. However, the present disclosure is not limited thereto. For example, the electroluminescent stacked elements EST may be arranged in a zigzag pattern along the first direction DR1 and the second direction DR2.

Each of the electroluminescent stacked elements EST may be circular with respect to the plane defined by the first direction DR1 and the second direction DR2. In such a case, each of the electroluminescent stacked elements EST may have a columnar shape. However, the present disclosure is not limited thereto. Each of the electroluminescent stacked elements EST may also be polygonal in shape (e.g., square or pentagonal).

The electroluminescent stacked elements EST may be configured to be substantially identical to each other. The following description refers to an electroluminescent stacked element EST among the electroluminescent stacked elements EST.

The electroluminescent stacked element EST may include a first semiconductor layer 100, a second semiconductor layer 200, an active layer 300, and an auxiliary electrode layer 400.

The first semiconductor layer 100 may be on top of an underlying semiconductor layer 500. The first semiconductor layer 100 may have a first polarity. The first semiconductor layer 100 may include at least one n-type semiconductor layer, and may be configured to provide electrons. For example, the first semiconductor layer 100 may include a semiconductor material of any one selected from gallium nitride (GaN), aluminium gallium nitride (AlGaN), indium gallium nitride (InGaN), aluminium nitride (AIN), and indium gallium nitride (InN), and may be an n-type semiconductor layer doped with an n-type dopant such as silicon (Si), germanium (Ge), tin (Sn), or the like. In an embodiment, the first semiconductor layer 100 may include a semiconductor material doped with n-type dopants, such as at least one selected from the group consisting of gallium nitride (GaN), aluminium nitride (AIN), and aluminium gallium nitride (AlGaN).

In an embodiment, the first semiconductor layer 100 may be integrally formed with the underlying semiconductor layer 500. In such cases, the underlying semiconductor layer 500 may include the same material as the first semiconductor layer 100. For example, the underlying semiconductor layer 500 may include a semiconductor material doped with n-type dopants, such as at least one selected from the group consisting of gallium nitride (GaN), aluminium nitride (AIN), and aluminium gallium nitride (AlGaN).

The second semiconductor layer 200 may be on top of the first semiconductor layer 100. The second semiconductor layer 200 may have a second polarity. The second semiconductor layer 200 may include at least one p-type semiconductor layer, and may be configured to provide holes. For example, the second semiconductor layer 200 may include a semiconductor material of at least one selected from gallium nitride (GaN), aluminium gallium nitride (AlGaN), indium gallium nitride (InGaN), aluminium nitride (AIN), and indium nitride (InN), and may be a p-type semiconductor layer doped with p-type dopants such as magnesium (Mg), zinc (Zn), calcium (Ca), strontium (Sr), barium (Ba), and/or the like. In an embodiment, the second semiconductor layer 200 may include a semiconductor material doped with p-type dopants, such as at least one selected from the group consisting of gallium nitride (GaN), aluminium nitride (AIN), and aluminium gallium nitride (AlGaN).

The active layer 300 may be between the first semiconductor layer 100 and the second semiconductor layer 200. The active layer 300 may provide a region where electrons and holes recombine. As electrons and holes recombine in the active layer 300, they may transition to lower energy levels, generating light with corresponding wavelengths. The active layer 300 may be formed to have a single quantum well structure or to have a multiple quantum well structure. If the active layer 300 is formed to have a multiple quantum well structure, units including a barrier layer, a strain reinforcement layer, and a well layer may be repeatedly stacked to form the active layer 300. However, the active layer 300 is not limited to the structure described above.

The auxiliary electrode layer 400 may be on top of the second semiconductor layer 200. The auxiliary electrode layer 400 may be in electrical contact with the second semiconductor layer 200. In an embodiment, the auxiliary electrode layer 400 may be referred to as an ohmic contact electrode. The auxiliary electrode layer 400 may be configured to be substantially transparent or translucent to meet a predetermined light transmittance. For example, the auxiliary electrode layer 400 may include a light-transmissive material that is conductive (e.g., electrically conductive). For example, the auxiliary electrode layer 400 may include at least one of various suitable transparent conductive materials such as indium tin oxide (ITO), indium zinc oxide (IZO), zinc oxide (ZnO), indium gallium zinc oxide (IGZO), indium tin zinc oxide (ITZO), and/or the like, but the present disclosure is not limited thereto. In an embodiment, the auxiliary electrode layer 400 may be omitted.

FIG. 4 is a schematic cross-sectional view to illustrate another embodiment of the deposition object of FIG. 2.

Referring to FIG. 4, the underlying semiconductor layer 500 (see FIG. 3) may be omitted compared to the embodiment described with reference to FIG. 3. In such a case, the electroluminescent stacked elements EST may be directly on the substrate SUB.

In an embodiment, the electroluminescent stacked elements EST having the columnar structure described with reference to FIGS. 2 to 4 may be formed by patterning by dry etching. In such cases, sidewall defects in the electroluminescent stacked elements EST caused by dry etching may cause non-radiative recombination, which may result in increased leakage current. Furthermore, as the electroluminescent stacked elements EST are miniaturized, the surface-to-volume ratio of the electroluminescent stacked elements EST increases, and thus the external quantum efficiency (EQE) may decrease relatively more significantly due to the occurrence of sidewall defects.

To prevent or reduce occurrence of the foregoing, an insulating layer (e.g., a first insulating layer IL1 (e.g., an electrically insulating layer such as, for example, a first electrically insulating layer IL1), see FIG. 21) may be formed that directly covers the outer peripheral surfaces of the electroluminescent stacked elements EST. Accordingly, the sidewall defects of the electroluminescent stacked elements EST may be reduced, and the external quantum efficiency may be improved.

If an oxide layer (e.g., Al₂O₃) is formed as an insulating layer (e.g., an electrically insulating layer) directly covering the outer peripheral surfaces of the electroluminescent stacked elements EST, the stability at the interface between such an oxide layer and the electroluminescent stacked elements EST may be problematic, and the subsequent thermal process may cause oxygen (O) penetration into the interior of the electroluminescent stacked elements EST. Therefore, it is necessary or useful to form a nitride layer as an insulating layer (e.g., an electrically insulating layer) directly covering the outer peripheral surfaces of the electroluminescent stacked elements EST.

As a method to form such a nitride layer, an atomic layer deposition (ALD) method may be used, which may secure uniform (e.g., substantially uniform) thickness and properties. In general, the atomic layer deposition method may be performed at a high process temperature (e.g., a process temperature of about 500 °C) to improve the quality of the nitride layer. However, at high process temperatures, damage to the electroluminescent stacked elements EST may occur. In embodiments, a plasma-enhanced atomic layer deposition (PEALD) method using plasma may be performed to improve the quality of the nitride layer. However, the plasma utilized in plasma-enhanced atomic layer deposition method may cause defects to form on the outer periphery of the electroluminescent stacked elements EST.

The present disclosure discloses a thermal atomic layer deposition method to solve the aforementioned problems. According to the thermal atomic layer deposition method of the present disclosure, the formation of the nitride layer is possible at a relatively low temperature, so that damage to the electroluminescent stacked elements EST caused by high temperature may be prevented or reduced, and defects caused by plasma may be prevented or reduced by not utilizing plasma.

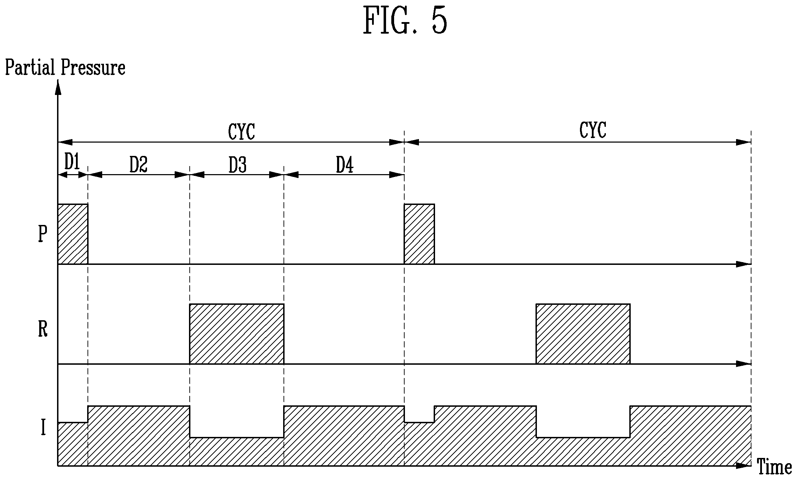

FIG. 5 is a diagram to illustrate a thermal atomic layer deposition method of embodiments of the present disclosure.

Referring to FIG. 5, the thermal atomic layer deposition method of embodiments of the present disclosure includes performing a thermal atomic layer deposition cycle CYC a plurality of times (or multiple times). The thermal atomic layer deposition cycle CYC may be performed, for example, within a chamber A (see FIG. 1).

In an embodiment, the thermal atomic layer deposition cycle CYC may include a first period D1, a second period D2, a third period D3, and a fourth period D4.

The first period D1 may correspond to an act of supplying a precursor P to a chamber A (see FIG. 1) loaded with a deposition object T (see FIGS. 1 to 4). The supplied precursor P may be chemisorbed via a ligand exchange reaction with the active side of the surface of the deposition object T (see FIGS. 1 to 4).

The second period D2 may correspond to an act of supplying an inert gas I to the chamber A (see FIG. 1). The supplied inert gas I may act as a purge gas to evacuate the physisorbed residual precursor P and reaction by-products outside the chamber A (see FIG. 1).

The third period D3 may correspond to an act of supplying the reactant R to the chamber A (see FIG. 1). The supplied reactant R may react with the chemisorbed precursor P. Accordingly, a thin layer (or thin film) and reaction by-products may be formed.

The fourth period D4 may correspond to an act of supplying an inert gas I to the chamber A (see FIG. 1). The supplied inert gas I may serve as a purge gas to evacuate residual reactants R and reaction by-products out of the chamber A (see FIG. 1).

According to the thermal atomic layer deposition cycle CYC described above, the thickness of the deposited thin layer may be precisely controlled based on a self-limiting reaction, and may exhibit good step coverage even for structures having high aspect ratios.

In an embodiment, the reactant R includes at least a nitrogen atom. For example, the reactant R may include NH₃, which has excellent reactivity with the precursor P described herein, but the present disclosure is not limited thereto.

In an embodiment, the precursor P includes at least one selected from the group consisting of tris(dimethylamide)gallium (TDMAGa) and tris(dimethylamino)aluminium (TDMAA). The tris(dimethylamide)gallium (TDMAGa) contains Ga-N bonds within its molecule and has excellent reactivity with the reactant R including a nitrogen atom (e.g., NH₃), and may be suitable to form a high-quality nitride layer (e.g., GaN thin layer) at relatively low temperatures. The tris(dimethylamino)aluminium (TDMAA) also has good reactivity with the reactant R including a nitrogen atom (e.g., NH₃) and may be suitable to form a high-quality nitride layer (e.g., GaN thin layer) at relatively low temperatures.

In an embodiment, the inert gas I may be a gas that does not react with the reactant R and the precursor P. For example, the inert gas I may include Ar, but the present disclosure is not limited thereto. The inert gas I may serve as a carrier gas to supply the precursor P in the first period D1 and as a carrier gas to supply the reactant R in the third period D3. The inert gas I may serve as a purge gas to purge reaction by-products and the like in the second period D2 and the fourth period D4.

In an embodiment, the inert gas I may serve to maintain a constant (e.g., substantially constant) pressure within the chamber A (see FIG. 1) while the thermal atomic layer deposition cycle CYC is being performed. For example, the partial pressure of the inert gas I during the first period D1 in which the precursor P is fed into the chamber A (see FIG. 1) may be less than the partial pressure of the inert gas I during the second period D2 and the fourth period D4. For example, the partial pressure of the inert gas I during the third period D3, in which the reactant R is supplied into the chamber A (see FIG. 1), may be less than the partial pressure of the inert gas I during the second period D2 and the fourth period D4. However, the present disclosure is not limited thereto. The partial pressure of the inert gas I may suitably vary depending on the deposition apparatus.

As the thermal atomic layer deposition cycle CYC is performed a plurality of times, the thin layers formed in the plurality of thermal atomic layer deposition cycles CYC may form a nitride layer (e.g., a first insulating layer IL1 (e.g., a first electrically insulating layer IL1), see FIG. 21) that directly covers the outer peripheral surfaces of the electroluminescent stacked elements EST (see FIGS. 3 and 4).

In an embodiment, the act of performing the thermal atomic layer deposition cycle CYC a plurality of times is performed at a temperature of about 150 °C or above and about 400 °C or below (e.g., in a range of 150 °C to 400 °C). If the act of performing the thermal atomic layer deposition cycle CYC a plurality of times is performed at a temperature below about 150 °C, an excessively low reactivity of the precursor P and the reactant R may occur. If the act of performing the thermal atomic layer deposition cycle CYC a plurality of times is performed at a temperature above about 400 °C, the electroluminescent stacked element EST (see FIGS. 3 and 4) may be damaged by high temperature.

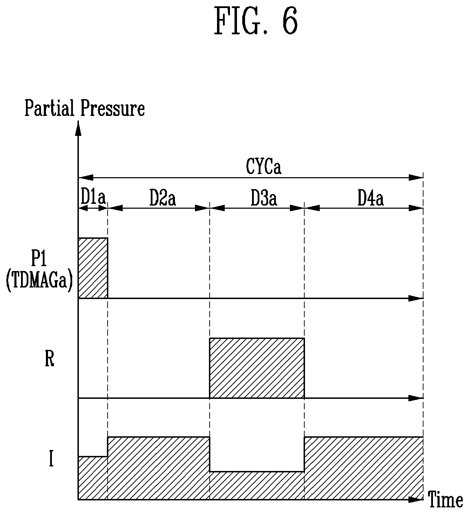

FIG. 6 is a diagram to illustrate a first thermal atomic layer deposition cycle.

Referring to FIG. 6, the thermal atomic layer deposition cycle CYC (see FIG. 5) may include a first thermal atomic layer deposition cycle CYCa.

The first thermal atomic layer deposition cycle CYCa may correspond to a deposition cycle utilizing a first precursor P1 as a precursor P. In embodiments, the first precursor P1 may be tris(dimethylamide)gallium (TDMAGa).

The first thermal atomic layer deposition cycle CYCa may include a first period D1a, a second period D2a, a third period D3a, and a fourth period D4a.

The first period D1a may correspond to an act of supplying a first precursor P1 to the chamber A (see FIG. 1). The supplied first precursor P1 may be chemisorbed via a ligand exchange reaction with active sites on the surface of the deposition object T (see FIGS. 1 to 4).

In this act, the time to supply the first precursor P1 may be from about 3 seconds to about 11 seconds or less. However, the time to supply the first precursor P1 may suitable vary depending on the deposition apparatus. If the time to supply the first precursor P1 is too long, productivity may be reduced due to an increase in process time, and the purge time in the subsequent second period D2a may increase. If the time to supply the first precursor P1 is too short, a saturation state may not be reached for a self-limiting reaction to occur.

In this act, the partial pressure of the first precursor P1 may be greater than about 10 mTorr and less than or equal to about 30 mTorr. However, the partial pressure of the first precursor P1 may suitably vary depending on the deposition apparatus.

The second period D2a may correspond to an act of supplying an inert gas I to the chamber A (see FIG. 1). The supplied inert gas I may serve as a purge gas to evacuate the physically adsorbed residual first precursor P1 and reaction by-products outside the chamber A (see FIG. 1).

In this act, the purge time by the supply of the inert gas I may be from about 40 seconds to about 80 seconds or more. However, this purge time may suitably vary depending on the deposition apparatus. If the time to purge the first precursor P1 is too long, productivity may be reduced due to an increase in process time. If the time to purge the first precursor P1 is too short, side reactions by the residual first precursor P1 may occur and the deposition device may be contaminated.

The third period D3a may correspond to an act of supplying the reactant R to the chamber A (see FIG. 1). The supplied reactant R may react with the chemisorbed first precursor P1. Accordingly, a gallium nitride (GaN) thin layer and reaction by-products may be formed.

In this act, the time to supply the reactant R may be from about 40 seconds to about 80 seconds or less. However, the time to supply the reactant R may suitably vary depending on the deposition apparatus. If the time to supply the reactant R is too long, productivity may be reduced due to the increase in process time, and the purge time in the subsequent fourth period D4a may increase. If the time to supply the reactant R is too short, not enough reaction with the first precursor P1 may occur.

In this act, the partial pressure of the reactant R may be greater than about 1 Torr and less than about 1.5 Torr. However, the partial pressure of the reactant R may suitably vary depending on the deposition apparatus.

The fourth period D4a may correspond to an act of supplying an inert gas I to the chamber A (see FIG. 1). The supplied inert gas I may act as a purge gas to evacuate residual reactants R and reaction by-products outside the chamber A (see FIG. 1).

In this act, the purge time by the supply of the inert gas I may be at least about 55 seconds and no more than about 95 seconds. However, this purge time may suitably vary depending on the deposition apparatus. If the time to purge the reactant R is too long, the productivity may be reduced due to the increase in process time. If the time to purge the reactant R is too short, side reactions with the residual reactants R may occur and the deposition device may be contaminated.

In an embodiment, the first thermal atomic layer deposition cycle CYCa may be performed at a temperature of about 300 °C or lower (e.g., in a range of 150 °C to 300 °C, 150 °C to 250 °C, or 175 °C to 225 °C). For example, the first thermal atomic layer deposition cycle CYCa may be performed at a temperature of about 150 °C or above and below about 300 °C (e.g., in a range of 150 °C to 300 °C). If the first thermal atomic layer deposition cycle CYCa is performed at a temperature greater than about 300 °C, the first precursor P1 may suffer from thermal decomposition due to the high temperature.

In an embodiment, the process pressure during the first thermal atomic layer deposition cycle CYCa may be maintained at about 1.5 Torr. For example, inert gas I may be supplied such that the pressure within chamber A (see FIG. 1) remains constant (e.g., substantially constant) while the first thermal atomic layer deposition cycle CYCa is being performed. However, the process pressure during the first thermal atomic layer deposition cycle CYCa may suitably vary depending on the deposition apparatus.

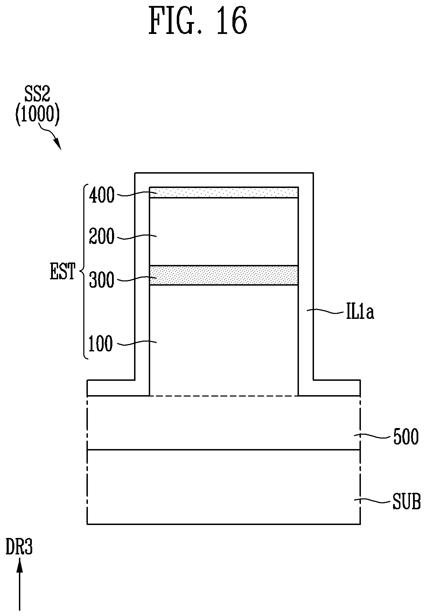

If the first thermal atomic layer deposition cycle CYCa is performed a plurality of times in succession, the gallium nitride (GaN) thin layers formed in the plurality of first thermal atomic layer deposition cycles CYCa may form a nitride layer (e.g., a GaN layer) (e.g., a first insulating layer IL1a (e.g., a first electrically insulating layer IL1a), see FIG. 16) that directly covers the outer peripheral surfaces of the electroluminescent stacked elements EST (see FIGS. 3 and 4).

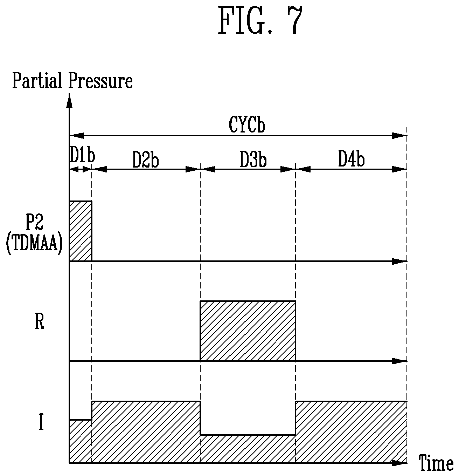

FIG. 7 is a diagram to illustrate a second thermal atomic layer deposition cycle.

Referring to FIG. 7, the thermal atomic layer deposition cycle CYC (see FIG. 5) may include a second thermal atomic layer deposition cycle CYCb.

The second thermal atomic layer deposition cycle CYCb may correspond to a deposition cycle utilizing a second precursor P2 as the precursor P. In embodiments, the second precursor P2 may be tris(dimethylamino)aluminium (TDMAA).

The second thermal atomic layer deposition cycle CYCb may include a first period D1b, a second period D2b, a third period D3b, and a fourth period D4b.

The first period D1b may correspond to an act of supplying a second precursor P2 to the chamber A (see FIG. 1). The supplied second precursor P2 may be chemisorbed via a ligand exchange reaction with active sites on the surface of the deposition object T (see FIGS. 1 to 4).

In this act, the time to supply the second precursor P2 may be from about 1 second to about 5 seconds or less. However, the time to supply the second precursor P2 may suitably vary depending on the deposition apparatus. If the time to supply the second precursor P2 is too long, productivity may be reduced due to increased process time, and the purge time in the subsequent second period D2b may increase. If the time to supply the second precursor P2 is too short, a saturation state may not be reached for a self-limiting reaction to occur.

In this act, the partial pressure of the second precursor P2 may be greater than about 10 mTorr and less than or equal to about 30 mTorr. However, the partial pressure of the second precursor P2 may suitably vary depending on the deposition apparatus.

The second period D2b may correspond to an act of supplying an inert gas I to the chamber A (see FIG. 1). The supplied inert gas I may serve as a purge gas to evacuate the physically adsorbed residual second precursor P2 and reaction by-products outside the chamber A (see FIG. 1).

In this act, the purge time by the supply of the inert gas I may be from about 40 seconds to about 80 seconds or more. However, this purge time may suitably vary depending on the deposition apparatus. If the time to purge the second precursor P2 is too long, the productivity may be reduced due to the increase in process time. If the time to purge the second precursor P2 is too short, side reactions with residual second precursor P2 may occur and the deposition device may be contaminated.

The third period D3b may correspond to an act of supplying the reactant R to the chamber A (see FIG. 1). The supplied reactant R may react with the chemisorbed second precursor P2. Accordingly, an aluminium nitride (AIN) thin layer and reaction by-products may be formed.

In this act, the time to supply the reactant R may be from about 40 seconds to about 80 seconds or less. However, the time to supply the reactant R may suitably vary depending on the deposition apparatus. If the time to supply the reactant R is too long, productivity may be reduced due to the increase in process time, and the purge time in the subsequent fourth period D4b may increase. If the time to supply the reactant R is too short, not enough reaction with the second precursor P2 may occur.

In this act, the partial pressure of the reactant R may be greater than about 0.75 Torr and less than or equal to about 1.25 Torr. However, the partial pressure of the reactant R may suitably vary depending on the deposition apparatus.

The fourth period D4b may correspond to an act of supplying an inert gas I to the chamber A (see FIG. 1). The supplied inert gas I may act as a purge gas to evacuate residual reactants R and reaction by-products outside the chamber A (see FIG. 1).

In this act, the purge time by the supply of the inert gas I may be from about 40 seconds to about 80 seconds or more. However, this purge time may suitably vary depending on the deposition apparatus. If the time to purge the reactant R is too long, the productivity may be reduced due to the increase in process time. If the time to purge the reactant R is too short, side reactions with the residual reactants R may occur and the deposition apparatus may be contaminated.

In an embodiment, the process pressure during the second thermal atomic layer deposition cycle CYCb may be maintained at about 1.5 Torr. For example, the inert gas I may be supplied such that the pressure within the chamber A (see FIG. 1) remains constant (e.g., substantially constant) while the second thermal atomic layer deposition cycle CYCb is performed. However, the process pressure during the second thermal atomic layer deposition cycle CYCb may suitably vary depending on the deposition apparatus.

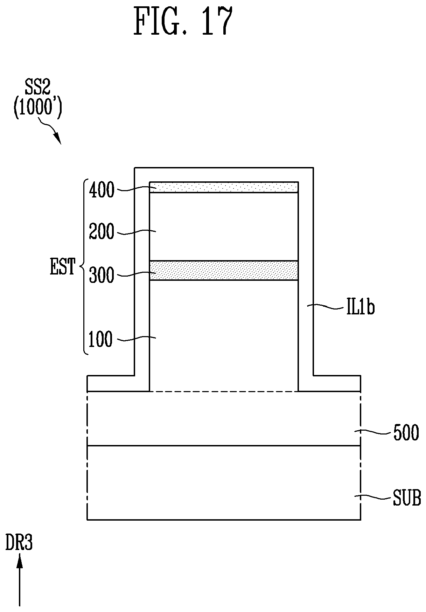

If (e.g., when) a plurality of second thermal atomic layer deposition cycles CYCb are performed in succession, the aluminium nitride (AIN) thin layers formed in the plurality of second thermal atomic layer deposition cycles CYCb may form a nitride layer (e.g., an aluminium nitride layer (AIN layer)) (e.g., a first insulating layer IL1b (e.g., a first electrically insulating layer IL1b), see FIG. 17) that directly covers the outer peripheral surfaces of the electroluminescent stacked elements EST (see FIGS. 3 and 4).

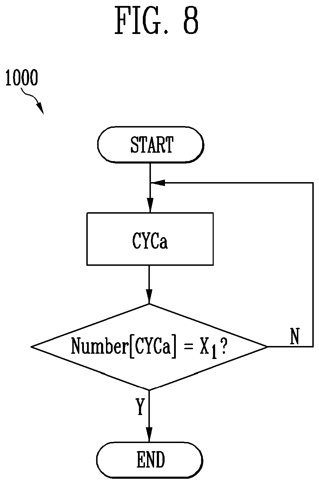

FIG. 8 is a flowchart to illustrate a first embodiment of a thermal atomic layer deposition method of the present disclosure.

Referring to FIG. 8, the act of performing a thermal atomic layer deposition cycle CYC (see FIG. 5) a plurality of times may include performing a first thermal atomic layer deposition cycle CYCa a plurality of times (e.g., X₁ times, where X₁ is a natural number greater than or equal to 2). According to the first embodiment of the thermal atomic layer deposition method 1000, a nitride layer (e.g., gallium nitride layer (GaN layer)) (e.g., the first insulating layer IL1a, see FIG. 16) may be formed that directly covers the outer peripheral surfaces of the electroluminescent stacked elements EST (see FIGS. 3 and 4).

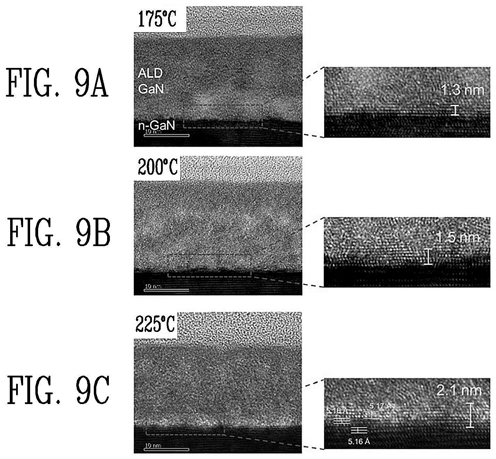

FIG. 9A, FIG. 9B, and FIG. 9C are a set of TEM images to illustrate a coherent interface of a first insulating layer (e.g., a first electrically insulating layer) formed by the thermal atomic layer deposition method of FIG. 8.

Referring to FIG. 9A, FIG. 9B, and FIG. 9C, a TEM image of a gallium nitride layer (GaN layer) (e.g., the first insulating layer IL1a, see FIG. 16) formed by the act of performing the first thermal atomic layer deposition cycle CYCa of FIG. 8 a plurality of times is shown. Such a gallium nitride layer was formed to directly cover gallium nitride (GaN) doped with n-type dopants (e.g., first semiconductor layer 100, see FIGS. 3 and 4). In embodiments, the n-type doped gallium nitride (GaN) (e.g., first semiconductor layer 100, see FIGS. 3 and 4) was loaded into chamber A (see FIG. 1) within 10 minutes of being immersed in a dilute BOE solution (NH₄F:HF=6:1, volume ratio) to remove the native oxide prior to performing the first thermal atomic layer deposition cycle CYCa.

If (e.g., when) the act of performing the first thermal atomic layer deposition cycle CYCa a plurality of times is performed at 175 °C, between a gallium nitride (GaN) doped with n-type dopants (e.g., first semiconductor layer 100, see FIGS. 3 and 4) and a gallium nitride layer (GaN layer) (e.g., the first insulating layer IL1a, see FIG. 16), it may be seen that a coherent interface having a thickness of about 1.3 nm appears. Furthermore, it may be seen that the gallium nitride (GaN) layer (e.g., the first insulating layer IL1a, see FIG. 16) has a structure in which a plurality of orientations of crystallites are formed in an amorphous matrix.

If (e.g., when) the act of performing the first thermal atomic layer deposition cycle CYCa a plurality of times is performed at 200 °C, between a gallium nitride (GaN) doped with n-type dopants (e.g., first semiconductor layer 100, see FIGS. 3 and 4) and a gallium nitride layer (GaN layer) (e.g., the first insulating layer IL1a, see FIG. 16), it may be seen that a coherent interface having a thickness of about 1.5 nm appears. Furthermore, it may be seen that the GaN layer (e.g., the first insulating layer IL1a, see FIG. 16) has a polycrystalline structure.

If (e.g., when) the act of performing the first thermal atomic layer deposition cycle CYCa a plurality of times is performed at 225 °C, between the gallium nitride (GaN) doped with n-type dopant (e.g., first semiconductor layer 100, see FIGS. 3 and 4) and the gallium nitride layer (GaN layer) (e.g., the first insulating layer IL1a, see FIG. 16), it may be seen that a coherent interface having a thickness of about 2.1 nm appears. Furthermore, it may be seen that the GaN layer (e.g., the first insulating layer IL1a, see FIG. 16) has a polycrystalline structure. In embodiments, it may be seen that the lattice spacing at the coherent interface is about 5.17±0.03 Angstroms, which is a wurtzite structure and corresponds to the c-plane, which is the same as that of gallium nitride (GaN) doped with n-type dopants (e.g., first semiconductor layer 100, see FIGS. 3 and 4).

Thus, it may be seen that according to the thermal atomic layer deposition method 1000 (see FIG. 8) according to the first embodiment of the present disclosure, a gallium nitride (GaN) layer (e.g., the first insulating layer IL1a, see FIG. 16) having very good conformity with the outer peripheral surface of the electroluminescent stacked element EST (see FIGS. 3 and 4) is provided, even at a relatively low process temperature and in an atomic layer deposition method that does not utilize plasma.

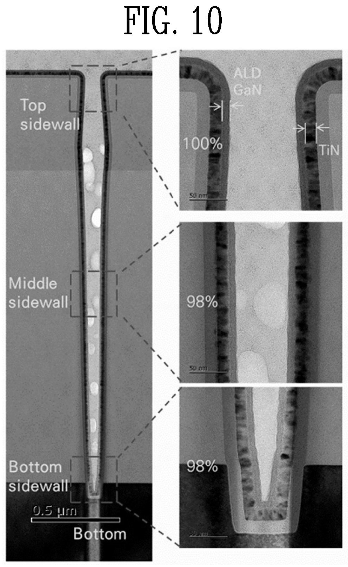

FIG. 10 is a TEM image to illustrate step coverage of the first insulating layer formed by the thermal atomic layer deposition method of FIG. 8.

Referring to FIG. 10, a TEM image of a gallium nitride layer (GaN layer) formed on a trench pattern having a high aspect ratio by the act of performing the first thermal atomic layer deposition cycle CYCa of FIG. 8 a plurality of times is shown. The trench pattern had an opening of about 28 nm and an aspect ratio of about 44.

The TEM image shown in FIG. 10 illustrates an embodiment of the act of performing the first thermal atomic layer deposition cycle CYCa a plurality of times at 200 °C. In the TEM image shown in FIG. 10, the step coverage on the top sidewall of the trench pattern was set to a baseline value of 100%. The TEM image shown in FIG. 10 shows the step coverage at each of the middle sidewall, bottom sidewall, and bottom relative to the baseline value. Table 1 below shows step coverage in embodiments where the act of performing the first thermal atomic layer deposition cycle CYCa a plurality of times was performed at various suitable process temperatures.

**Table 1**

| | 175 °C | 200 °C | 225 °C |
|---|---|---|---|
| Step coverage at Middle sidewall compared to Top sidewall | 98% or more | 98% or more | 98% or more |
| Step coverage at Bottom sidewall compared to Top sidewall | 98% or more | 98% or more | about 89% |
| Step coverage at Bottom compared to Top sidewall | 98% or more | 98% or more | about 82% |

Referring to Table 1, it may be seen that the step coverage of the gallium nitride layer (GaN layer) is very good, greater than 80% in all areas, if (e.g., when) the act of performing the first thermal atomic layer deposition cycle CYCa a plurality of times is performed at 175 °C, 200 °C, and 225 °C.

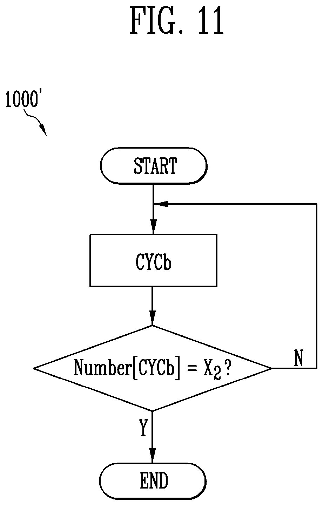

FIG. 11 is a flowchart to illustrate a second embodiment of the thermal atomic layer deposition method of the present disclosure.

Referring to FIG. 11, the act of performing thermal atomic layer deposition cycle CYC (see FIG. 5) a plurality of times may include an act of performing a second thermal atomic layer deposition cycle CYCb a plurality of times (e.g., X₂ times, where X₂ is a natural number greater than or equal to 2). According to the second embodiment of the thermal atomic layer deposition method 1000', a nitride layer (e.g., an aluminium nitride layer (AIN layer)) (e.g., the first insulating layer IL1b, see FIG. 17) that directly covers the outer peripheral surfaces of the electroluminescent stacked elements EST (see FIGS. 3 and 4) may be formed.

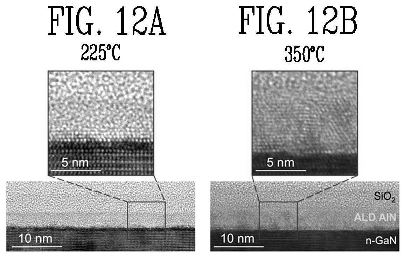

FIG. 12A and FIG. 12B are a set of TEM images to illustrate a coherent interface of a first insulating layer (e.g., a first electrically insulating layer) formed by the thermal atomic layer deposition method of FIG. 11.

Referring to FIG. 12A and FIG. 12B, a TEM image of an aluminium nitride layer (AIN) (e.g., the first insulating layer IL1b, see FIG. 17) formed by the act of performing the second thermal atomic layer deposition cycle CYCb a plurality of times of FIG. 11 is shown. Such an aluminium nitride layer is formed to directly cover gallium nitride (GaN) doped with n-type dopants (e.g., first semiconductor layer 100, see FIGS. 3 and 4). In embodiments, the n-type dopant-doped gallium nitride (GaN) (e.g., first semiconductor layer 100, see FIGS. 3 and 4) was loaded into chamber A (see FIG. 1) within 10 minutes of removal of the native oxide layer by immersion in a dilute BOE solution (NH₄F:HF=6:1, volume ratio) prior to performing the second thermal atomic layer deposition cycle CYCb.

If (e.g., when) the act of performing the second thermal atomic layer deposition cycle CYCb a plurality of times is performed at 225 °C, between the gallium nitride (GaN) doped with n-type dopants (e.g., first semiconductor layer 100, see FIGS. 3 and 4) and the aluminium nitride (AIN) layer (e.g., the first insulating layer IL1b, see FIG. 17), it may be seen that a coherent interface appears.

Similarly, if (e.g., when) the act of performing the second thermal atomic layer deposition cycle CYCb a plurality of times is performed at 350 °C, between the gallium nitride (GaN) doped with n-type dopant (e.g., first semiconductor layer 100, see FIGS. 3 and 4) and the aluminium nitride (AIN) layer (e.g., the first insulating layer IL1b, see FIG. 17), it may be seen that a coherent interface appears.

Thus, according to the thermal atomic layer deposition method 1000' (see FIG. 11) according to the second embodiment of the present disclosure, it may be seen that an aluminium nitride layer (AIN layer) (e.g., the first insulating layer IL1b, see FIG. 17) having a very good coherent interface with the outer peripheral surface of the electroluminescent stacked element EST (see FIGS. 3 and 4) is provided, even at a relatively low process temperature and in an atomic layer deposition method that does not utilize plasma.

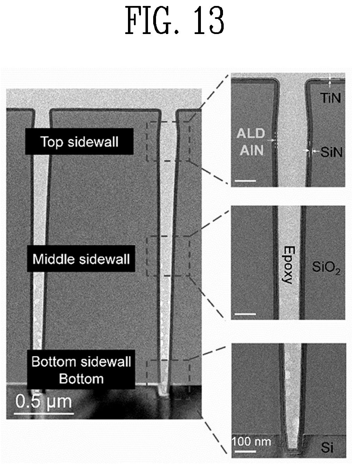

FIG. 13 is a TEM image to illustrate step coverage of the first insulating layer formed by the thermal atomic layer deposition method of FIG. 11.

Referring now to FIG. 13, a TEM image of an aluminium nitride layer (AIN layer) formed on a trench pattern having a high aspect ratio by the act of performing the second thermal atomic layer deposition cycle CYCb a plurality of times of FIG. 11 is shown.

The TEM image shown in FIG. 13 illustrates an embodiment of the act of performing the second thermal atomic layer deposition cycle CYCb a plurality of times at 300 °C. In the TEM image shown in FIG. 13, the step coverage on the top side of the trench pattern is set to a baseline value of 100%, and the step coverage of on the middle side, bottom side, and bottom relative to the baseline value is shown in Table 2 below. The step coverage at various suitable process temperatures in addition to 300 °C is shown in Table 2 below.

**Table 2**

| | 200 °C | 250 °C | 300 °C | 325 °C | 350 °C |
|---|---|---|---|---|---|
| Step coverage at Middle sidewall compared to Top sidewall | 99% or more | 99% or more | 99% or more | about 92% | about 93% |
| Step coverage at Bottom sidewall compared to Top sidewall | 99% or more | 99% or more | 99% or more | about 88% | about 85% |
| Step coverage at Bottom compared to Top sidewall | 99% or more | 99% or more | 99% or more | about 88% | about 85% |

Referring to Table 2, it may be seen that for the cases where the act of performing the second thermal atomic layer deposition cycle CYCb a plurality of times is performed at 200 °C, 250 °C, 300 °C, 325 °C, and 350 °C, the step coverage of the aluminium nitride layer (AIN layer) is very good, greater than 85% in all areas.

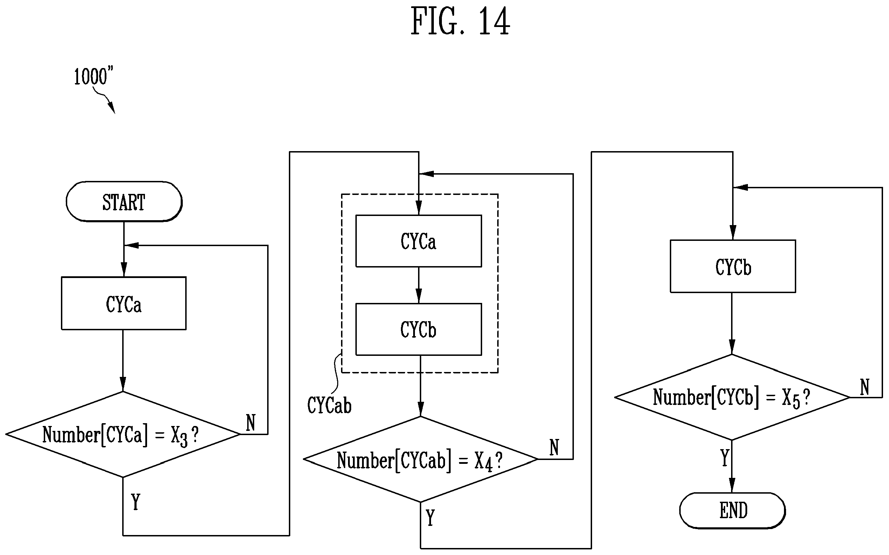

FIG. 14 is a flowchart to illustrate a third embodiment of the thermal atomic layer deposition method of the present disclosure.

Referring to FIG. 14, the act of performing the thermal atomic layer deposition cycle CYC (see FIG. 5) a plurality of times may include an act of performing the first thermal atomic layer deposition cycle CYCa a plurality of times, an act of performing the first thermal atomic layer deposition cycle CYCa and the second thermal atomic layer deposition cycle CYCb alternately a plurality of times, and an act of performing the second thermal atomic layer deposition cycle CYCb a plurality of times.

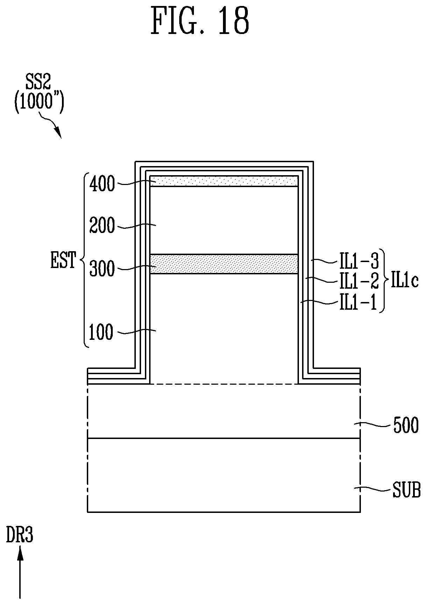

By the act of performing the first thermal atomic layer deposition cycle CYCa a plurality of times (e.g., X₃ times, where X₃ is a natural number greater than or equal to 2), a first nitride layer (e.g., a gallium nitride layer (GaN layer)) (e.g., a first-1 insulating layer IL1-1 (e.g., a first-1 electrically insulating layer IL1-1), see FIG. 18) directly covering the outer peripheral surfaces of the electroluminescent stacked elements EST (see FIGS. 3 and 4) may be formed. The first nitride layer may have very good conformability with the outer peripheral surface of the electroluminescent stacked element EST (see FIGS. 3 and 4), as described with reference to FIG. 9A, FIG. 9B, and FIG. 9C.

By the act of performing the first thermal atomic layer deposition cycle CYCa and the second thermal atomic layer deposition cycle CYCb alternately a plurality of times (e.g., X₄ times, wherein X₄ is a natural number greater than or equal to 2), a second nitride layer (e.g., an aluminium gallium nitride layer (AlGaN layer)) (e.g., a first-2 insulating layer IL1-2 (e.g., a first-2 electrically insulating layer IL1-2), see FIG. 18) directly covering the first nitride layer may be formed. In embodiments, "performing the first thermal atomic layer deposition cycle CYCa and the second thermal atomic layer deposition cycle CYCb alternately" may have the same meaning as "performing the first thermal atomic layer deposition cycle CYCa once followed by the second thermal atomic layer deposition cycle CYCb once" and may be referred to as an "alternating cycle CYCab".

In an embodiment, the act of performing the alternating cycles CYCab a plurality of times may be performed at a temperature of about 300 °C or lower (e.g., in a range of 150 °C to 300 °C). For example, the act of performing the alternating cycles CYCab a plurality of times may be performed at a temperature of greater than about 150 °C and less than or equal to about 300 °C (e.g., in a range of 150 °C to 300 °C). If the alternating cycle CYCab is performed at a temperature greater than about 300 °C, the first precursor P1 (see FIG. 6) may suffer from thermal decomposition due to the high temperature.

By the act of performing the second thermal atomic layer deposition cycle CYCb a plurality of times, a third nitride layer (e.g., an aluminium nitride layer (AIN layer)) (e.g., a first-3 insulating layer IL1-3 (e.g., a first-3 electrically insulating layer IL1-3), see FIG. 18) directly covering the second nitride layer may be formed. The third nitride layer may have excellent insulating properties (e.g., excellent electrically insulating properties).

In embodiments, the second nitride layer, which is an aluminium gallium nitride layer (AlGaN layer), may play a role in matching the lattice structure of the first nitride layer, which is a gallium nitride layer (GaN layer), and the lattice structure of the third nitride layer, which is an aluminium nitride layer (AIN layer). Accordingly, according to the thermal atomic layer deposition method 1000" according to the third embodiment of the present disclosure, excellent conformity with the outer peripheral surface of the electroluminescent stacked element EST (see FIGS. 3 and 4) may be secured by the first nitride layer, excellent insulating properties (e.g., excellent electrically insulating properties) may be secured by the third nitride layer, and stability between the first nitride layer and the third nitride layer may be secured by the second nitride layer.

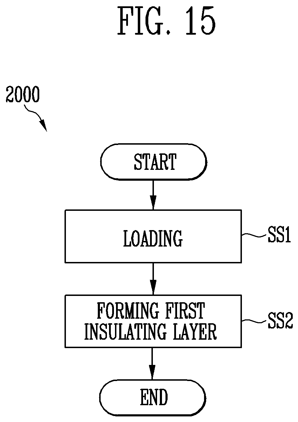

FIG. 15 is a flowchart to illustrate a method of manufacturing a light emitting element of the present disclosure.

Referring to FIG. 15, the method 2000 of manufacturing a light emitting element of the present disclosure includes an act SS1 of loading a substrate SUB (see

FIGS. 3 and 4) on which the electroluminescent stacked elements EST (see FIGS. 3 and 4) are provided into a chamber A (see FIG. 1), and an act SS2 of forming a first insulating layer (e.g., a first electrically insulating layer) directly covering the outer peripheral surfaces of the electroluminescent stacked elements EST (see FIGS. 3 and 4) by performing a thermal atomic layer deposition cycle a plurality of times.

The thermal atomic layer deposition cycle may be described similarly to that described with reference to FIGS. 1 to 14. Accordingly, description of redundant content may not be repeated.

Hereinafter, in FIGS. 16 to 19 and FIGS. 21 to 24, only one electroluminescent stacked element EST is shown, but this is for illustrative purposes only. Those skilled in the art will understand that the description of the electroluminescent stacked element EST of FIGS. 16 to 19 and FIGS. 21 to 24 is applicable to any of the electroluminescent stacked elements EST of FIGS. 2 to 4.

FIG. 16 is a schematic cross-sectional view to illustrate a first embodiment of a first insulating layer (e.g., a first electrically insulating layer) formed by the act of forming the first insulating layer of FIG. 15.

Referring to FIG. 16, the act SS2 of forming the first insulating layer may be performed by the thermal atomic layer deposition method 1000 described with reference to FIG. 8. Accordingly, a first insulating layer IL1a (e.g., a first electrically insulating layer IL1a) including a gallium nitride layer (GaN) may be formed. In embodiments, the act SS2 of forming the first insulating layer according to the first embodiment of the present disclosure may include forming a first insulating layer IL1a (e.g., a first electrically insulating layer IL1a) directly covering the outer peripheral surface of the electroluminescent stacked element EST by performing the first thermal atomic layer deposition cycle CYCa (see FIG. 8) a plurality of times.

For the first insulating layer IL1a, the description of the first insulating layer IL1a as described with reference to FIGS. 8 to 10 may be similarly applied, and redundant descriptions may not be repeated.

FIG. 17 is a schematic cross-sectional view to illustrate a second embodiment of the first insulating layer formed by the act of forming the first insulating layer of FIG. 15.

Referring to FIG. 17, the act SS2 of forming the first insulating layer may be performed by the thermal atomic layer deposition method 1000' described with reference to FIG. 11. Accordingly, a first insulating layer IL1b (e.g., a first electrically insulating layer IL1b) including aluminium nitride (AIN) may be formed. In embodiments, the act SS2 of forming the first insulating layer according to a second embodiment of the present disclosure may include forming a first insulating layer IL1b (e.g., a first electrically insulating layer IL1b) directly covering the outer peripheral surface of the electroluminescent stacked element EST by performing the second thermal atomic layer deposition cycle CYCb (see FIG. 11) a plurality of times.

For the first insulating layer IL1b, the description of the first insulating layer IL1b as described with reference to FIGS. 11 to 13 may be similarly applied, and redundant descriptions may not be repeated.

FIG. 18 is a schematic cross-sectional view to illustrate a third embodiment of the first insulating layer formed by the act of forming the first insulating layer of FIG. 15.

Referring to FIG. 18, the act SS2 of forming the first insulating layer may be performed by the thermal atomic layer deposition method 1000" described with reference to FIG. 14. Accordingly, a first insulating layer IL1c (e.g., a first electrically insulating layer IL1c) including a first-1 insulating layer IL1-1 (e.g., a first-1 electrically insulating layer IL1-1) including gallium nitride (GaN), a first-2 insulating layer IL1-2 (e.g., a first-2 electrically insulating layer IL1-2) including aluminium gallium nitride (AlGaN), and a first-3 insulating layer IL1-3 (e.g., a first-3 electrically insulating layer IL1-3) including aluminium nitride (AIN) may be formed. In embodiments, the act SS2 of forming the first insulating layer according to the third embodiment of the present disclosure may include an act of forming a first-1 insulating layer IL1-1 (e.g., a first-1 electrically insulating layer IL1-1) directly covering the outer peripheral surface of the electroluminescent stacked element EST by performing the first thermal atomic layer deposition cycle CYCa (see FIG. 14) a plurality of times; an act of forming a first-2 insulating layer IL1-2 (e.g., a first-2 electrically insulating layer IL1-2) directly covering the first-1 insulating layer IL1-1 by performing the alternating cycle CYCab (see FIG. 14) a plurality of times; and an act of forming a first-3 insulating layer IL1-3 (e.g., a first-3 electrically insulating layer IL-3) directly covering the first-2 insulating layer IL1-2 by performing the second thermal atomic layer deposition cycle CYCb (see FIG. 14) a plurality of times.

For the first insulating layer IL1c including the first-1 insulating layer IL1-1, the first-2 insulating layer IL1-2, and the first-3 insulating layer IL1-3, the description described with reference to FIG. 14 may be similarly applied, and redundant descriptions may not be repeated.

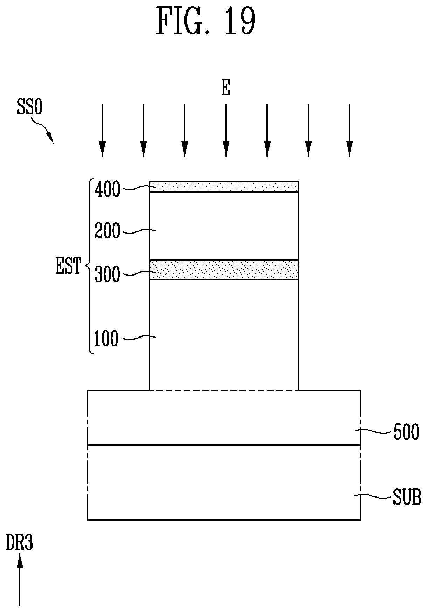

FIG. 19 is a schematic cross-sectional view to illustrate an act of removing a natural oxide layer.

Referring to FIG. 19, the method 2000 of manufacturing a light emitting element (see FIG. 15) may further include an act SS0 of removing a native oxide layer on an outer peripheral surface of an electroluminescent stacked element EST. The native oxide layer may be formed by atmospheric oxidation of the electroluminescent stacked element EST. If the native oxide layer is present, a problem may arise in which a coherent interface is not formed between the first insulating layer IL1a, IL1b, or IL1c formed by the thermal atomic layer deposition method 1000, 1000', or 1000" of the present disclosure and the outer peripheral surface of the electroluminescent stacked element EST.

In an embodiment, the act SS0 of removing the natural oxide layer may be performed prior to the loading act SS1 (see FIG. 15). In such a case, the natural oxide layer may be substantially absent on the outer peripheral surface of the electroluminescent stacked element EST contained in the deposition object T (see FIG. 1) being loaded into the chamber A (see FIG. 1).

In an embodiment, the act SS0 of removing the natural oxide layer may be performed by etching E. For example, the etching E may include wet etching. The wet etching may be performed, for example, using a BOE solution or a dilute solution of a BOE solution, but the present disclosure is not limited thereto. In another example, the etching E may include a vapor phase etching. The vapor phase etching may be performed, for example, by atomic layer etching (ALE) in which HF and a metal precursor are alternately fed, but the present disclosure is not limited thereto.

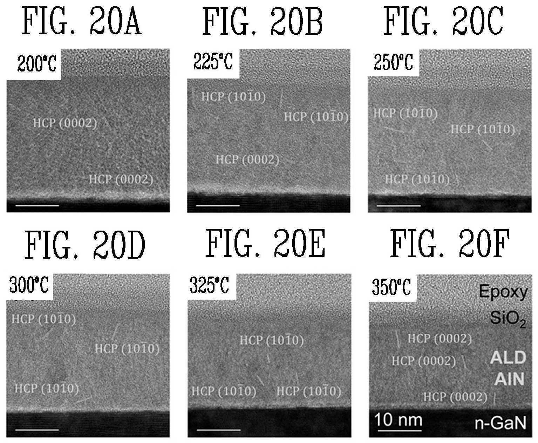

FIG. 20A, FIG. 20B, FIG. 20C, FIG. 20D, FIG. 20E, and FIG. 20F are a set of TEM images to illustrate that a coherent interface is substantially absent if (e.g., when) the first insulating layer is formed without performing the act of removing the natural oxide layer.

Referring to FIG. 20A, FIG. 20B, FIG. 20C, FIG. 20D, FIG. 20E, and FIG. 20F, a TEM image of an aluminium nitride layer (AIN layer) formed by performing act SS2 (see FIG. 17) to form a first insulating layer IL1b (e.g., a first electrically insulating layer IL1b) without performing act SS0 (see FIG. 19) to remove the natural oxide layer.

In embodiments in which the act SS2 (see FIG. 17) of forming the first insulating layer IL1b without performing the act SS0 (see FIG. 19) of removing the natural oxide layer (see FIG. 17) was performed at various suitable temperatures (e.g., 200 °C, 225 °C, 250 °C, 300 °C, 325 °C, or 350 °C), between the aluminium nitride layer (AIN layer) and the gallium nitride (GaN) doped with n-type dopant (e.g., the first semiconductor layer 100) (e.g., the first semiconductor layer 100,FIG. 17), it may be seen that no coherent interface is formed.

FIG. 21 is a schematic cross-sectional view to illustrate an act of forming a second insulating layer (e.g., a second electrically insulating layer).

Referring to FIG. 21, the method 2000 of manufacturing a light emitting element (see FIG. 15) may further include an act SS3 of forming a second insulating layer IL2 (e.g., a second electrically insulating layer IL2) that directly covers the first insulating layer IL1. In embodiments, the first insulating layer IL1 may correspond to the first insulating layer IL1a described with reference to FIG. 16, the first insulating layer IL1b described with reference to FIG. 17, or the first insulating layer IL1c described with reference to FIG. 18.

In an embodiment, the second insulating layer IL2 may include an oxide layer. For example, the second insulating layer IL2 may include SiO₂, but the present disclosure is not limited thereto. For example, the second insulating layer IL2 may include HfO₂, and/or Al₂O₃, which have excellent insulating properties (e.g., excellent electrically insulating properties) and relatively large dielectric constants. The second insulating layer IL2, which is an oxide layer, may directly cover the first insulating layer IL1, which is a nitride layer, and thereby serve to prevent or reduce oxidation of the first insulating layer IL1 by atmospheric exposure.

In FIG. 21, the second insulating layer IL2 is shown as a monolayer structure, but the present disclosure is not limited thereto. For example, similar to the first insulating layer IL1c shown in FIG. 18, the second insulating layer IL2 may have a multi-layer structure including a plurality of oxide layers. In such a case, the plurality of oxide layers included in the second insulating layer IL2 may be composed of the same material, or may be composed of different materials.

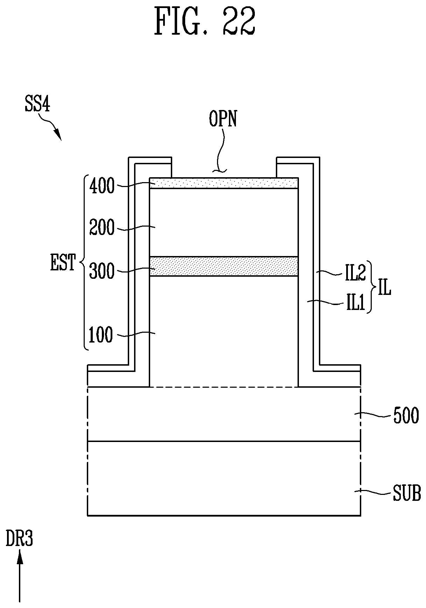

FIG. 22 is a schematic cross-sectional view to illustrate an act of forming an opening.

Referring to FIG. 22, the method 2000 of manufacturing a light emitting element (see FIG. 15) may further include an act SS4 of forming an opening OPN that exposes at least a portion of a top surface of the electroluminescent stacked element EST.

The act SS4 of forming the opening OPN may include removing a portion of an insulating layer IL (e.g., an electrically insulating layer IL) covering the electroluminescent stacked element EST. In embodiments, the insulating layer IL may include a first insulating layer IL1 (e.g., a first electrically insulating layer IL1) and a second insulating layer IL2 (e.g., a second electrically insulating layer IL2), as described above. In an embodiment, a portion of the top surface of the auxiliary electrode layer 400 may be exposed by the opening OPN.

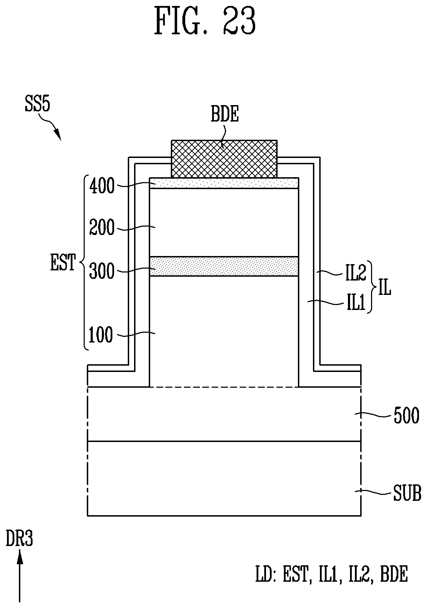

FIG. 23 is a schematic cross-sectional view to illustrate an act of forming a bonding electrode.

Referring to FIG. 23, the method 2000 of manufacturing a light emitting element (see FIG. 15) may further include an act SS5 of forming a bonding electrode BDE within the opening OPN.

In an embodiment, the bonding electrode BDE may be in direct contact with the auxiliary electrode layer 400. In such a case, the bonding electrode BDE may be electrically connected to the second semiconductor layer 200 via the auxiliary electrode layer 400. In an embodiment, the bonding electrode BDE may include a eutectic metal, but the present disclosure is not limited thereto.

Accordingly, a light emitting element LD including the electroluminescent stacked element EST, the first insulating layer IL1, the second insulating layer IL2, and the bonding electrode BDE may be formed.

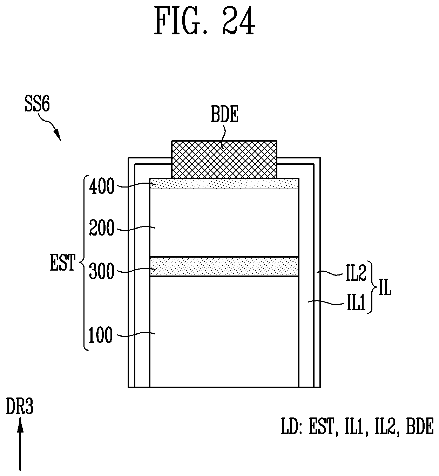

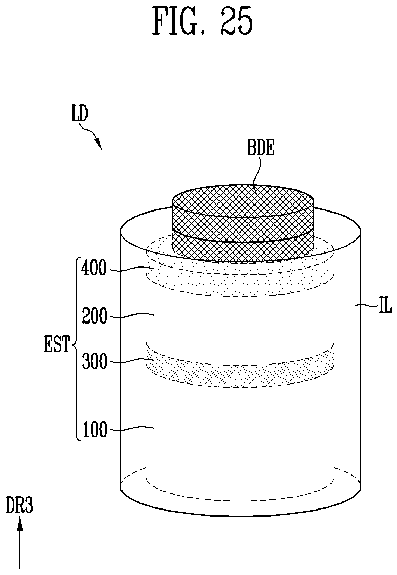

FIG. 24 is a schematic cross-sectional view to illustrate an act of isolating the light emitting element. FIG. 25 is a schematic perspective view illustrating the light emitting element of FIG. 24.

Referring to FIGS. 24 and 25, the method 2000 (see FIG. 15) of manufacturing a light emitting element may further include an act SS6 of isolating the light emitting element LD. For example, the light emitting element LD may be separated from the underlying semiconductor layer 500. For example, if the underlying semiconductor layer 500 is omitted, as described with reference to FIG. 4, the light emitting element LD may be separated from the substrate SUB.

The act SS6 of separating the light emitting element LD may be performed by various suitable separation methods generally used in the art. For example, the light emitting element LD may be separated by a physical separation method and/or a chemical separation method. For example, the light emitting element LD may be separated by a laser lift-off method.

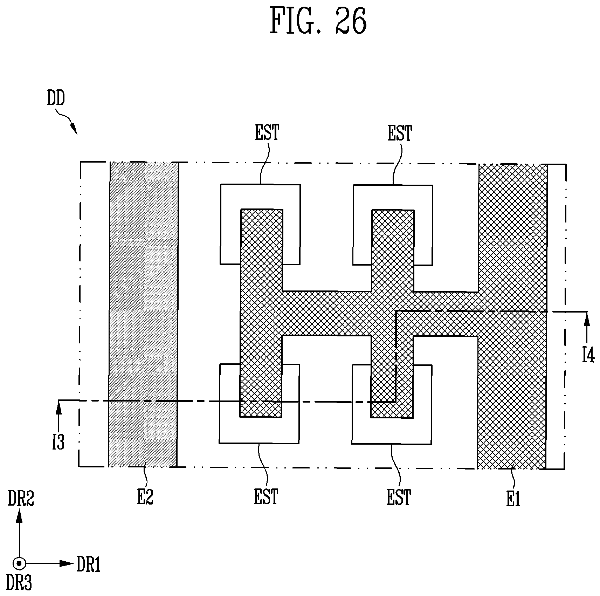

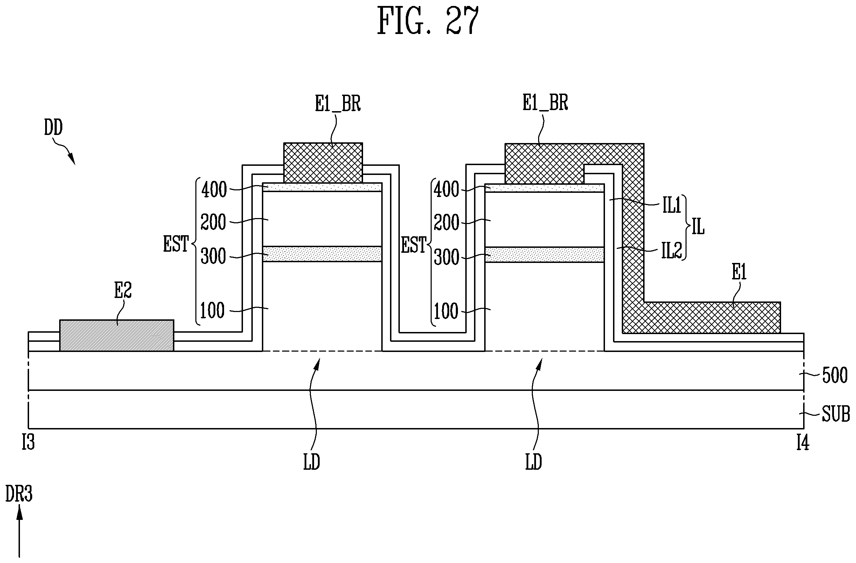

The light emitting element LD separated in this act may be provided to a display device or an electronic device manufactured separately and utilized as a light source. However, the present disclosure is not limited thereto. For example, the act SS5 of forming the bonding electrode BDE (see FIG. 23) may be replaced by an act of forming a first electrode E1 (see FIGS. 26 and 27), and the act SS6 of separating the light emitting element LD may be omitted. In such a case, the light emitting element LD may form a part of a display device DD (see FIGS. 26 and 27) together with the underlying semiconductor layer 500.

FIG. 26 is a schematic plan view to illustrate a display device according to an embodiment of the present disclosure. FIG. 27 is a schematic cross-sectional view cut along line I3-I4 of FIG. 26.

Referring to FIGS. 26 and 27, the display device DD may include a substrate SUB, an underlying semiconductor layer 500, light emitting elements LD, a first electrode E1, and a second electrode E2.

The substrate SUB and underlying semiconductor layer 500 may be described similarly to which is described with reference to FIGS. 2 and 3. Accordingly, description of redundant content may not be repeated.

Each of the light emitting elements LD may include an electroluminescent stacked element EST, an insulating layer IL (e.g., an electrically insulating layer IL), and a bridge electrode E1_BR.

The electroluminescent stacked element EST may be described similarly to the electroluminescent stacked element EST described with reference to FIG. 3, except that the electroluminescent stacked element EST has a square column shape. As such, the EST may have a variety of suitable shapes.

In an embodiment, the insulating layer IL may include a first insulating layer IL1 (e.g., a first electrically insulating layer IL1) that is a nitride layer and a second insulating layer IL2 (e.g., a second electrically insulating layer IL2) that is an oxide layer. In such a case, the first insulating layer IL1 and the second insulating layer IL2 may be described as described with reference to FIGS. 15 to 25.

The bridge electrode E1_BR may penetrate the insulating layer IL and contact the auxiliary electrode layer 400 through an opening (e.g., opening OPN in FIG. 22) that exposes at least a portion of the top surface of the electroluminescent stacked element EST. Accordingly, the bridge electrode E1_BR may be electrically connected to the second semiconductor layer 200 via the auxiliary electrode layer 400.

The first electrode E1 may be electrically connected to the bridge electrode E1_BR. For example, the first electrode E1 may include a body portion extending in the second direction DR2, and a branch portion that branches from the body portion to electrically connect with the bridge electrode E1_BR. In such cases, in an embodiment, the branch portion and the bridge electrode E1_BR may be integrally formed. For example, the bridge electrode E1_BR may be viewed as corresponding to an end of the branch portion. The first electrode E1 may be electrically isolated from the underlying semiconductor layer 500. For example, an insulating layer IL (e.g., an electrically insulating layer IL) may be between the first electrode E1 and the underlying semiconductor layer 500.

The second electrode E2 may be spaced apart from the first electrode E1. The second electrode E2 may be embedded in the insulating layer IL and may be in contact with the underlying semiconductor layer 500. Accordingly, the second electrode E2 may be electrically connected to the first semiconductor layer 100 via the underlying semiconductor layer 500.

The light emitting element LD may emit light based on a first voltage applied to the first electrode E1 and a second voltage applied to the second electrode E2. As such, the display device DD may be a device that emits light using the light emitting element LD.

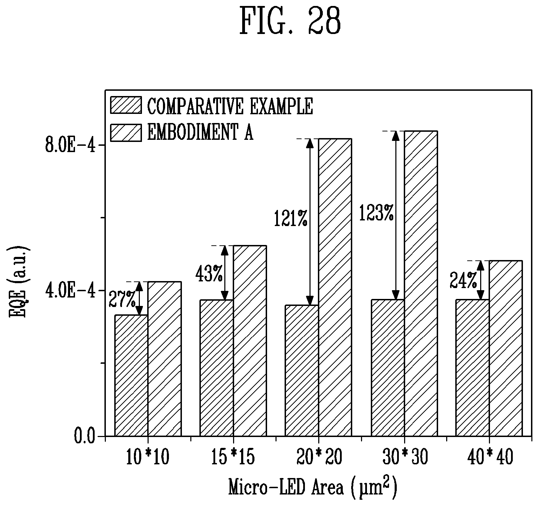

FIGS. 28 to 30 are graphs illustrating the external quantum efficiency of a light emitting element according to material constituting the insulating layer of FIG. 27.

In FIGS. 28 to 30, the external quantum efficiency of a light emitting element LD (see FIG. 27) included in a display device DD (see FIGS. 26 and 27) according to a material including an insulating layer IL (e.g., an electrically insulating layer IL; see FIG. 27) included in the display device DD (see FIGS. 26 and 27) is shown.

In embodiments, the electroluminescent stacked element EST (see FIGS. 26 and 27) included in the light emitting element LD (see FIG. 27) has a square shape having various suitable areas (e.g., 10 µm x 10 µm, 15 µm x 15 µm, 20 µm x 20 µm, 30 µm x 30 µm, 40 µm x 40 µm) relative to a plane defined by the first direction DR1 and the second direction DR2, and a height in a third direction DR3 of 800 nm is used.

Furthermore, the external quantum efficiency is shown as the photocurrent divided by the injection current measured using a probe station (MST 8000, MSTECH).

In FIGS. 28 to 29, a comparative example uses an HfO₂ monolayer layer deposited using TEMAHf as a precursor and O₃ as a reactant at 150 °C as an insulating layer IL (e.g., an electrically insulating layer; see FIG. 27).

An embodiment A used a gallium nitride layer (GaN layer) deposited by performing the thermal atomic layer deposition method 1000 (see FIG. 8) according to the first embodiment of the present disclosure at 225 °C as a first insulating layer IL1 (e.g., a first electrically insulating layer IL1; see FIG. 27), and SiO₂ as a second insulating layer IL2 (e.g., a second electrically insulating layer IL2).

An embodiment B uses an aluminium nitride layer (AIN layer) deposited by performing the thermal atomic layer deposition method 1000' (see FIG. 11) according to the second embodiment of the present disclosure at 225 °C as the first insulating layer IL1 (see FIG. 27), and SiO₂ as the second insulating layer IL2.

An embodiment C uses an aluminium nitride layer (AIN layer) deposited by performing the thermal atomic layer deposition method 1000' (see FIG. 11) according to the second embodiment of the present disclosure at 350 °C as a first insulating layer IL1 (e.g., a first electrically insulating layer IL1; see FIG. 27), and SiO₂ as a second insulating layer IL2 (e.g., a second electrically insulating layer IL2).

Referring to FIG. 28, it may be seen that the embodiment A exhibits a superior external quantum efficiency compared to the comparative example for light emitting elements LD (see FIG. 27) having areas of 10 µm x 10 µm, 15 µm x 15 µm, 20 µm x 20 µm, 30 µm x 30 µm, and 40 µm x 40 µm, respectively.

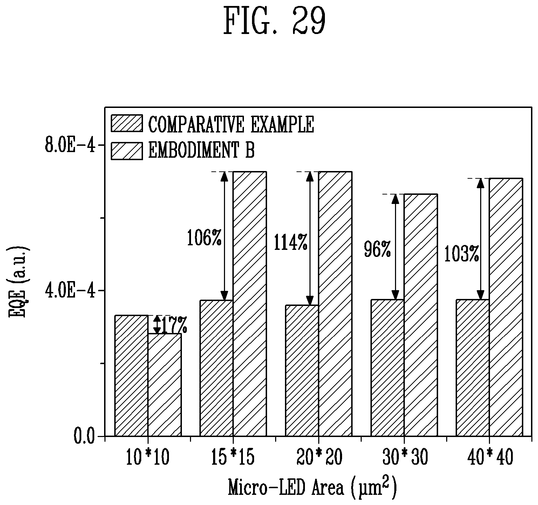

Referring to FIG. 29, it may be seen that the embodiment B exhibits a superior external quantum efficiency compared to the comparative example for the light emitting elements LD (see FIG. 27) having areas of 15 µm x 15 µm, 20 µm x 20 µm, 30 µm x 30 µm, and 40 µm x 40 µm, respectively.

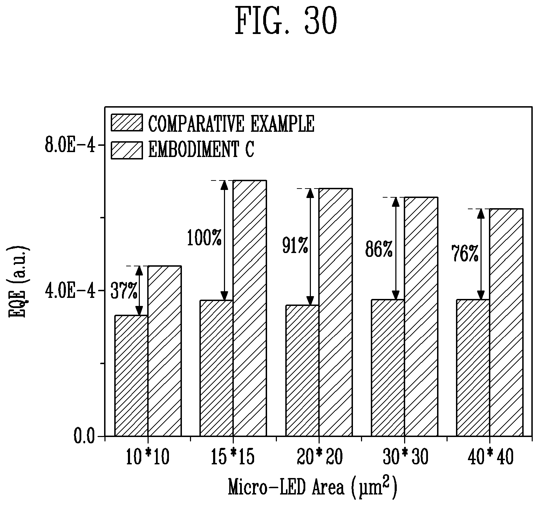

Referring to FIG. 30, it may be seen that the embodiment C exhibits a superior external quantum efficiency compared to the comparative example for the light emitting elements LD (see FIG. 27) having areas of 10 µm x 10 µm, 15 µm x 15 µm, 20 µm x 20 µm, 30 µm x 30 µm, and 40 µm x 40 µm, respectively.

As such, it may be seen that the external quantum efficiency of the light emitting element may be improved according to the thermal atomic layer deposition method of embodiments of the present disclosure.

The light emitting element according to embodiments and the display device including the same may be applied to various suitable electronic devices. In an embodiment, an electronic device may include the light emitting element (or the display device including the same) as described above, and may further include modules or devices having other additional functions.

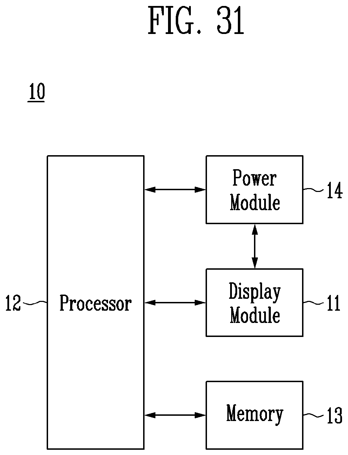

FIG. 31 is a block diagram of an electronic device according to an embodiment. Referring to FIG. 31, the electronic device 10 according to an embodiment may include a display module 11, a processor 12, a memory 13, and a power module 14.

The processor 12 may include at least one selected from a central processing unit (CPU), an application processor (AP), a graphics processing unit (GPU), a communication processor (CP), an image signal processor (ISP), and a controller.

The memory 13 may store data information necessary or useful for operation of the processor 12 and/or the display module 11. If (e.g., when) the processor 12 executes an application stored in the memory 13, image data signals and/or input control signals may be provided to the display module 11, and the display module 11 may process the provided signals to display the image via the display screen.

The power module 14 may include a power supply module, such as a power adapter and/or a battery unit, and a power conversion module that converts the power supplied by the power supply module to generate the power required or useful for operation of the electronic device 10.

The aforementioned electronic device 10 may include a light emitting element according to the aforementioned embodiments. In embodiments, at least one of each of the aforementioned configurations of the electronic device 10 may be included within the display device according to the aforementioned embodiments. Furthermore, some of the individual modules that are functionally included within one module may be included within the display device and others may be provided separately from the display device. For example, the display device may include the display module 11, while the processor 12, the memory 13, and the power module 14 may be provided in the form of other devices within the electronic device 10 other than the display device.

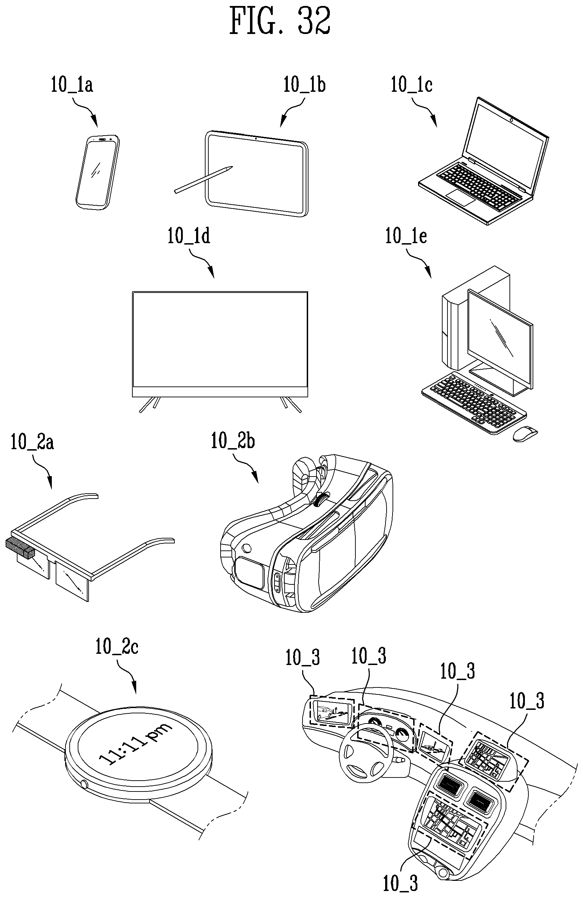

FIG. 32 is a schematic diagram of an electronic device according to various embodiments.

Referring to FIG. 32, various suitable electronic devices with display devices according to embodiments include electronic devices to display images, such as a smartphone 10_1a, a tablet PC 10_1b, a laptop 10_1c, a television 10_1d, a desk monitor 10_1e, as well as wearable electronic devices including display modules such as a smart glass 10_2a, a head-mounted display 10_2b, a smart watch 10_2c, and the like, automotive electronic devices 10_3 including display modules such as a center information display CID, a room mirror display, and/or the like on an instrument panel, a center fascia, or a dashboard of an automobile, and/or the like.

Although the subject matter of the present disclosure has been described with reference to the embodiments herein, it will be understood by those skilled in the art that various suitable modifications and changes can be made to the subject matter of the present disclosure without departing from the ideas and scope of the present disclosure described in the following patent claims, and equivalents thereof.

## Claims

1. A thermal atomic layer deposition method comprising:
performing a thermal atomic layer deposition cycle (CYC) a plurality of times,
wherein the thermal atomic layer deposition cycle (CYC) comprises:
supplying a precursor (P) to a chamber (A) loaded with a substrate (SUB) on which electroluminescent stacked elements (EST) are provided; and
supplying a reactant (R) to the chamber (A),
wherein the precursor (P) comprises at least one selected from a group consisting of tris(dimethylamide)gallium and tris(dimethylamino)aluminium,
wherein the reactant (R) comprises at least a nitrogen atom, and
wherein the performing the thermal atomic layer deposition cycle (CYC) a plurality of times is performed at a temperature of 150 °C or above and 400 °C or below.

2. The thermal atomic layer deposition method of claim 1, wherein the thermal atomic layer deposition cycle (CYC) comprises a first thermal atomic layer deposition cycle (CYCa),
wherein the first thermal atomic layer deposition cycle (CYCa) comprises:
supplying tris(dimethylamide)gallium to the chamber (A); and
supplying the reactant (R) to the chamber (A).

3. The thermal atomic layer deposition method of claim 2, wherein the first thermal atomic layer deposition cycle (CYCa) is performed at a temperature of 300 °C or below.

4. The thermal atomic layer deposition method of claim 2 or claim 3, wherein the thermal atomic layer deposition cycle (CYC) comprises a second thermal atomic layer deposition cycle (CYCb),
wherein the second thermal atomic layer deposition cycle (CYCb) comprises:
supplying tris(dimethylamino)aluminium to the chamber (A); and
supplying the reactant (R) to the chamber (A).

5. The thermal atomic layer deposition method of claim 4, wherein the performing the thermal atomic layer deposition cycle (CYC) a plurality of times comprises:
performing the first thermal atomic layer deposition cycle (CYCa) a plurality of times;
performing the first thermal atomic layer deposition cycle (CYCa) and the second thermal atomic layer deposition cycle (CYCb) alternately a plurality of times; and
performing the second thermal atomic layer deposition cycle (CYCb) a plurality of times, optionally wherein the performing the first thermal atomic layer deposition cycle (CYCa) and the second thermal atomic layer deposition cycle (CYCb) alternately a plurality of times is performed at a temperature of 300 °C or below.

6. The thermal atomic layer deposition method of any one of claims 1 to 5, wherein the reactant (R) comprises NH₃.

7. A method of manufacturing a light emitting element (LD) comprising:
loading a substrate (SUB) on which electroluminescent stacked elements (EST) are provided into a chamber (A); and
forming a first insulating layer (IL1, IL1a, IL1b, IL1c) directly covering outer peripheral surfaces of the electroluminescent stacked elements (EST) by performing a thermal atomic layer deposition cycle (CYC) a plurality of times,
wherein the thermal atomic layer deposition cycle (CYC) comprises:
supplying a precursor (P) into the chamber (A); and
supplying a reactant (R) into the chamber (A),
wherein the precursor (P) comprises at least one selected from a group consisting of tris(dimethylamide)gallium and tris(dimethylamino)aluminium,
wherein the reactant (R) comprises at least a nitrogen atom, and
wherein the forming the first insulating layer (IL1, IL1a, IL1b, IL1c) is performed at a temperature of 150 °C or above and 400 °C or below.

8. The method of manufacturing a light emitting element (LD) of claim 7, further comprising:
removing a native oxide layer on the outer peripheral surfaces of the electroluminescent stacked elements (EST).

9. The method of manufacturing a light emitting element (LD) of claim 8, wherein the removing the native oxide layer is performed prior to loading the substrate (SUB) into the chamber (A).

10. The method of manufacturing a light emitting element (LD) of any one of claims 7 to 9, wherein each of the electroluminescent stacked elements (EST) comprises a first semiconductor layer (100) having a first polarity, a second semiconductor layer (200) having a second polarity different from the first polarity, and an active layer (300) between the first semiconductor layer (100) and the second semiconductor layer (200),
wherein the first semiconductor layer (100) and the second semiconductor layer (200) comprise at least one selected from a group consisting of gallium nitride (GaN), aluminium nitride (AIN), and aluminium gallium nitride (AlGaN).

11. The method of manufacturing a light emitting element (LD) of any one of claims 7 to 10, wherein the thermal atomic layer deposition cycle (CYC) includes a first thermal atomic layer deposition cycle (CYCa),
wherein the first thermal atomic layer deposition cycle (CYCa) includes:
supplying tris(dimethylamide)gallium to the chamber (A); and
supplying the reactant (R) to the chamber (A), optionally wherein the first thermal atomic layer deposition cycle (CYCa) is performed at a temperature of 300 °C or below.

12. The method of manufacturing a light emitting element (LD) of claim 11, wherein the thermal atomic layer deposition cycle (CYC) includes a second thermal atomic layer deposition cycle (CYCb),
wherein the second thermal atomic layer deposition cycle (CYCb) includes:
supplying tris(dimethylamino)aluminium to the chamber (A); and
supplying the reactant (R) to the chamber (A).

13. The method of manufacturing a light emitting element (LD) of claim 12, wherein the of forming the first insulating layer (ILc) includes:
forming a first-1 insulating layer (IL1-1) directly covering the outer peripheral surfaces of the electroluminescent stacked elements (EST) by performing the first thermal atomic layer deposition cycle (CYCa) a plurality of times;
forming a first-2 insulating layer (IL1-2) directly covering the first-1 insulating layer (IL1-1) by performing the first thermal atomic layer deposition cycle (CYCa) and the second thermal atomic layer deposition cycle (CYCb) alternately a plurality of times; and
forming a first-3 insulating layer (IL1-3) directly covering the first-2 insulating layer (IL1-2) by performing the second thermal atomic layer deposition cycle (CYCb) a plurality of times.

14. The method of manufacturing a light emitting element (LD) of claim 13, wherein:
(i) the forming the first-2 insulating layer (IL1-2) is performed at a temperature of 300 °C below; and/or(ii) the first-1 insulating layer (IL1-1) includes gallium nitride,
the first-2 insulating layer (IL1-2) includes aluminum gallium nitride, and
the first-3 insulating layer (IL1-3) includes aluminum nitride.

15. An electronic device (10) comprising:
a display device (DD) to display an image; and
a processor (12) to provide image data signals to the display device (DD),
wherein the display device (DD) comprises a light emitting element (LD), and
wherein the light emitting element (LD) is manufactured by the method of any one of claims 7 to 14.
